(19) Europäisches Patentamt
European Patent Office
Office européen des brevets

(11) EP 3 223 329 A1

(12) EUROPEAN PATENT APPLICATION
published in accordance with Art. 153(4) EPC

(43) Date of publication:
**27.09.2017 Bulletin 2017/39**

(21) Application number: **15861295.2**

(22) Date of filing: **19.11.2015**

(51) Int Cl.:
***H01L 51/46*** *(2006.01)* ***H01L 51/44*** *(2006.01)*

(86) International application number:
**PCT/JP2015/082559**

(87) International publication number:
**WO 2016/080489 (26.05.2016 Gazette 2016/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **21.11.2014 JP 2014236632**

(71) Applicant: **FUJIFILM Corporation**
**Tokyo 106-8620 (JP)**

(72) Inventors:
- **YAMAMOTO, Yosuke**
  **Ashigarakami-gun**
  **Kanagawa 258-8577 (JP)**
- **SATOU, Hirotaka**
  **Ashigarakami-gun**
  **Kanagawa 258-8577 (JP)**
- **KOBAYASHI, Katsumi**
  **Ashigarakami-gun**
  **Kanagawa 258-8577 (JP)**

(74) Representative: **Hoffmann Eitle**
**Patent- und Rechtsanwälte PartmbB**
**Arabellastraße 30**
**81925 München (DE)**

# (54) PHOTOELECTRIC CONVERSION ELEMENT, SOLAR CELL AND METHOD FOR PRODUCING PHOTOELECTRIC CONVERSION ELEMENT

(57) To provide a photoelectric conversion element which has a photoelectric conversion efficiency that does not significantly fluctuate, is capable of exhibiting stable cell performance, and, furthermore, has excellent moisture resistance and high-humidity light resistance, a solar cell, and a method for manufacturing a photoelectric conversion element.

Provided are a photoelectric conversion element including: a first electrode having a photosensitive layer including a light absorber on a conductive support; a second electrode facing the first electrode; and a hole transport layer provided between the first electrode and the second electrode, in which the light absorber includes a compound having a perovskite-type crystal structure having a cation of an element in Group 1 of the periodic table or a cationic organic group A, a cation of a metallic atom M that is not an element in Group 1 of the periodic table, and an anion that is an anionic atom X, and a content of an organic solvent per cubic millimeter of the hole transport layer is $1\times10^{-10}$ to $1\times10^{-7}$ mol, a solar cell for which this photoelectric conversion element is used, and a method for manufacturing a photoelectric conversion element including a step of applying a hole-transporting material solution and drying the hole-transporting material solution at 40°C to 180°C.

EP 3 223 329 A1

FIG. 1

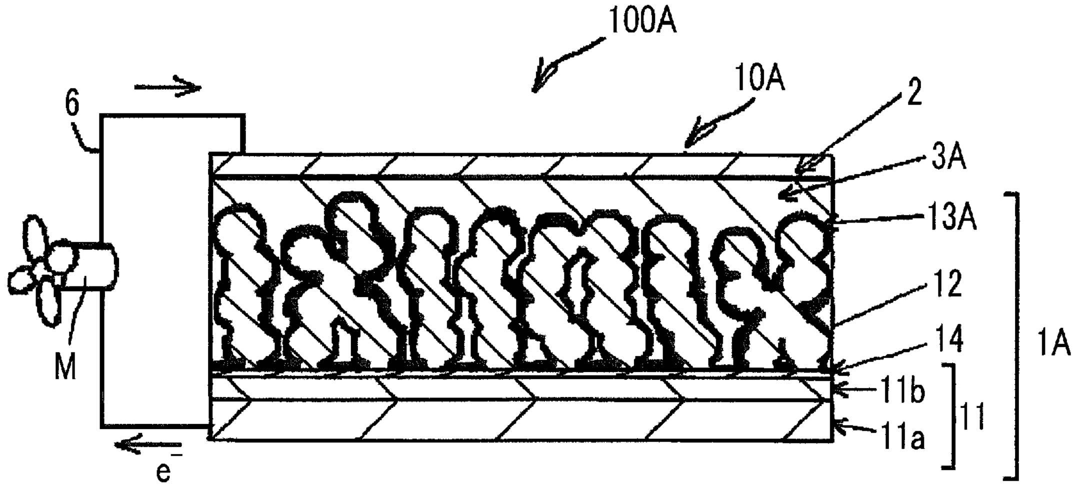

**Description**

**BACKGROUND OF THE INVENTION**

1. Field of the Invention

The present invention relates to a photoelectric conversion element, a solar cell, and a method for manufacturing a photoelectric conversion element.

2. Description of the Related Art

Photoelectric conversion elements are used in a variety of optical sensors, copiers, solar cells, and the like. It is anticipated that solar cells will be actively put into practical use as cells using non-exhaustible solar energy. Among them, active research and development is underway regarding dye sensitized solar cells in which an organic coloring agent, a Ru bipyridyl complex, or the like is used as a sensitizer, and the photoelectric conversion efficiency thereof reaches approximately 11%.

Meanwhile, in recent years, there have been reports of research results that solar cells in which a metal halide is used as a compound having a perovskite-type crystal structure are capable of achieving a relatively high photoelectric conversion efficiency.

For example, WO2014/045021A describes a photovoltaic device having perovskite including a first cation, a second cation, and at least one halide anion or chalcogenide anion.

In Journal of the American Chemical Society, 2014, 136, pp. 7,837 to 7,840, a solar cell having organic and inorganic hybrid perovskite is described, and hole-transporting materials are studied.

**SUMMARY OF THE INVENTION**

As described above, photoelectric conversion elements and solar cells in which a compound having a perovskite-type crystal structure (hereinafter, in some cases, referred to as a perovskite compound) is used have attained certain achievements in terms of the improvement of photoelectric conversion efficiencies. However, these photoelectric conversion elements and solar cells have been attracting attention in recent years, but there is no sufficient amount of knowledge about cell performance other than photoelectric conversion efficiencies.

As a result of repetitively manufacturing the solar cells using a perovskite compound of a metal halide or the like and the same manufacturing method in the above-described circumstances, it was found that there is a huge variation in photoelectric conversion efficiencies among the obtained solar cells and the stability of cell performance is not sufficient.

In addition, for photoelectric conversion elements and solar cells, there is a demand not only for a high photoelectric conversion efficiency but also for durability enough to maintain initial performance in on-site environments in which the photoelectric conversion elements and solar cells are actually used. However, for photoelectric conversion elements and solar cells in which a perovskite compound is used as a light absorber, the photoelectric conversion efficiencies decrease over time in highly humid environments, and the moisture resistance cannot be said to be sufficient. Furthermore, when the photoelectric conversion elements and the solar cells receive light in highly humid environments, the decrease in the photoelectric conversion efficiencies are accelerated, and the light resistance in highly humid environments (high-humidity light resistance) cannot be said to be sufficient.

An object of the present invention is to provide a photoelectric conversion element which has a photoelectric conversion efficiency that does not significantly fluctuate, is capable of exhibiting stable cell performance, and, furthermore, has excellent moisture resistance and high-humidity light resistance and a solar cell for which the photoelectric conversion element is used. In addition, another object of the present invention is to provide a method for manufacturing a photoelectric conversion element which has a photoelectric conversion efficiency that does not significantly fluctuate, is capable of exhibiting stable cell performance, and, furthermore, has excellent moisture resistance and high-humidity light resistance.

In the manufacturing of photoelectric conversion elements and solar cells in which a perovskite compound is used as a light absorber for a photosensitive layer, the present inventors paid attention to hole transport layers provided adjacent to the photosensitive layer instead of the photosensitive layer which has been thus far studied and carried out studies. As a result, it was found that, when a specific content of an organic solvent is added to the hole transport layer or the like, the fluctuation (variation) of the photoelectric conversion efficiencies of photoelectric conversion elements or solar cells decreases and, furthermore, the moisture resistance and the high-humidity light resistance can be improved. The present invention has been completed on the basis of the above-described finding.

That is, the objects are achieved by means of the following means.

[1] A photoelectric conversion element comprising: a first electrode having a photosensitive layer including a light absorber on a conductive support; a second electrode facing the first electrode; and a hole transport layer provided between the first electrode and the second electrode, in which the light absorber includes a compound having a perovskite-type crystal structure having a cation of an element in Group 1 of the periodic table or a cationic organic group A, a cation of a metallic atom M that is not an element in Group 1 of the periodic table, and an anion that is an anionic atom X, and a content of an organic solvent per cubic millimeter of the hole transport layer is $1\times10^{10}$ to $1\times10^{-7}$ mol.

[2] The photoelectric conversion element according to [1], in which the organic solvent is an organic solvent having a specific permittivity of 2.0 to 25.0.

[3] The photoelectric conversion element according to [2], in which the organic solvent is an organic solvent having a specific permittivity of 2.5 to 5.0 or 10.0 to 25.0.

[4] The photoelectric conversion element according to [2] or [3], in which the organic solvent is an organic solvent having a specific permittivity of 2.5 to 5.0.

[5] The photoelectric conversion element according to any one of [1] to [4], in which the content of the organic solvent per cubic millimeter of the hole transport layer is $1\times10^{-9}$ to $5\times10^{-8}$ mol.

[6] The photoelectric conversion element according to any one of [1] to [5], in which the hole transport layer is formed by means of coating.

[7] The photoelectric conversion element according to [6], in which the hole transport layer is dried at 40°C to 180°C.

[8] A solar cell comprising: the photoelectric conversion element according to any one of [1] to [7].

[9] A method for manufacturing a photoelectric conversion element including a first electrode having a photosensitive layer including a light absorber on a conductive support, a second electrode facing the first electrode, and a hole transport layer provided between the first electrode and the second electrode, in which the light absorber includes a compound having a perovskite-type crystal structure having a cation of an element in Group 1 of the periodic table or a cationic organic group A, a cation of a metallic atom M that is not an element in Group 1 of the periodic table, and an anion that is an anionic atom X, comprising at least: a step of applying a hole-transporting material solution including a hole-transporting material and an organic solvent onto the first electrode and drying the hole-transporting material solution at 40°C to 180°C.

In the present specification, regarding the respective formulae, there are cases in which a part of the formula is expressed as a rational formula for understanding of the chemical structure of a compound. Accordingly, in the respective formulae, partial structures are called groups (substituents), ions, atoms, or the like; however, in the present specification, there are cases in which the partial structures will refer to element groups or elements constituting groups (substituents) or ions represented by the above-illustrated formulae in addition to groups (substituents), ions, atoms, or the like.

In the present specification, the expression of compounds (including complexes and coloring agents) is used to indicate not only the compounds themselves but also salts or ions thereof. In addition, the expression indicates compounds having a structure that is partially modified to an extent in which the target effects are not impaired. Furthermore, compounds in which it is not clearly stated whether the compounds are substituted or unsubstituted compounds may be compounds having an arbitrary substituent as long as the target effects are not impaired. What has been described above shall also apply to substituents, linking groups, and the like (hereinafter, substituents and the like).

In the present specification, when there are multiple substituents and the like expressed using a specific reference symbol or multiple substituents and the like are specified at the same time, the respective substituents and the like may be identical to or different from each other unless particularly otherwise described. What has been described above shall also apply to the specification regarding the number of substituents and the like. In addition, when multiple substituents and the like are close to each other (for example, are adjacent to each other), the substituents and the like may be linked to each other and thus form a ring unless particularly otherwise described. In addition, rings, for example, alicycles, aromatic rings, and hetero rings may be further fused together and thus form a fused ring.

In addition, in the present specification, numerical ranges expressed using "to" include numerical values before and after the "to" as the lower limit value and the upper limit value.

Due to the present invention, it is possible to provide a photoelectric conversion element which has a photoelectric conversion efficiency that does not significantly fluctuate, is capable of exhibiting stable cell performance, and, furthermore, has excellent moisture resistance and high-humidity light resistance, a solar cell for which the same photoelectric conversion element is used, and a method for manufacturing the solar cell.

The above-described and other characteristics and advantages of the present invention will be further clarified from the following description with appropriate reference to the accompanying drawings.

## BRIEF DESCRIPTION OF THE DRAWINGS

Fig. 1 is a cross sectional view schematically illustrating a preferred aspect of a photoelectric conversion element of the present invention.

Fig. 2 is a cross sectional view schematically illustrating a preferred aspect of the photoelectric conversion element of the present invention including a thick photosensitive layer.

Fig. 3 is a cross sectional view schematically illustrating another preferred aspect of the photoelectric conversion element of the present invention.

## DESCRIPTION OF THE PREFERRED EMBODIMENTS

<<Photoelectric conversion element>>

A photoelectric conversion element of the present invention has a first electrode having a photosensitive layer including a light absorber on a conductive support, a second electrode facing the first electrode, and a hole transport layer provided between the first electrode and the second electrode. The photosensitive layer, the hole transport layer, and the second electrode are provided on the conductive support in this order.

The light absorber includes at least one of perovskite compounds described below.

In the present invention, "having the photosensitive layer on the conductive support" means that the photosensitive layer is provided in contact with the surface of the conductive support or the photosensitive layer is provided above the surface of the conductive support through another layer.

In the aspect in which the photosensitive layer is provided above the surface of the conductive support through another layer, the layer that is provided between the conductive support and the photosensitive layer is not particularly limited as long as the layer does not degrade the cell performance of solar cells. Examples thereof include a porous layer, a blocking layer, an electron transport layer, and the like.

In the present invention, examples of the aspect in which the photosensitive layer is provided above the surface of the conductive support through another layer include an aspect in which the photosensitive layer is provided on the surface of a porous layer in a thin film shape or the like (refer to Fig. 1), an aspect in which the photosensitive layer is provided on the surface of a porous layer in a thick film shape (refer to Fig. 2), an aspect in which the photosensitive layer is provided on the surface of a blocking layer in a thin film shape, and an aspect in which the photosensitive layer is provided on the surface of a blocking layer in a thick film shape (refer to Fig. 3). The photosensitive layer may be provided in a linear shape or in a dispersed pattern, but is preferably provided in a film shape.

There is no particular limitation regarding constitutions unless particularly specified in the present invention, and well-known constitutions relating to photoelectric conversion elements and solar cells can be employed for the photoelectric conversion element of the present invention. The respective layers constituting the photoelectric conversion element of the present invention are designed according to their purposes and may have a monolayer form or a multilayer form.

The photoelectric conversion element of the present invention includes the organic solvent in the hole transport layer in a content described below. Therefore, it is possible to impart any of stable cell performance, moisture resistance, and high-humidity light resistance to photoelectric conversion elements and solar cells.

As described above, depending on the content of the organic solvent included in the hole transport layer, the characteristic of the photoelectric conversion element can be improved. Therefore, in the present invention, the content of the organic solvent is determined by the molar amount per cubic millimeter of the hole transport layer.

In a case in which the photoelectric conversion element of the present invention includes a plurality of types of organic solvents in the hole transport layer, the content of the organic solvent refers to the total content of the respective organic solvents.

The content of the organic solvent is $1\times10^{-10}$ to $1\times10^{-7}$ mol in terms of the content per cubic millimeter of the hole transport layer. When the content of the organic solvent per cubic millimeter of the hole transport layer (hereinafter, in some cases, simply referred to as the content of the organic solvent) is less than $1\times10^{-10}$ mol, the hole transport layer needs to be excessively dried in order to remove the organic solvent in the formation of the hole transport layer. As a result, defects are generated in the layer structure of the hole transport layer, and cell performance, moisture resistance, or high-humidity light resistance deteriorates. On the other hand, when the content of the organic solvent is more than $1\times10^{-7}$ mol, it is not possible to effectively suppress changes in the layer structure during the manufacturing of the hole transport layer and over time. As a result, cell performance, moisture resistance, or high-humidity light resistance deteriorates.

The content of the organic solvent is preferably $1\times10^{-9}$ to $5\times10^{-8}$ mol and more preferably $5\times10^{-9}$ to $5\times10^{-8}$

mol from the viewpoint of cell performance, moisture resistance, or high-humidity light resistance.

The organic solvent is not particularly limited, but is derived from organic solvents present in liquid prepared to mainly form the hole transport layer (also referred to as hole-transporting material solution).

The organic solvent is preferably an organic solvent capable of dissolving hole-transporting materials enough to prepare the hole-transporting material solution. Here, "being capable of dissolving hole-transporting materials" means that "1 mL of the organic solvent is capable of dissolving at least 1 mg of a hole-transporting material".

Examples of the above-described organic solvent include aromatic solvents, halogen solvents, nitrile solvents, amide solvents, sulfur-containing solvents, ether solvents, nitrogen-containing heterocyclic solvents, ketone solvents, and ester solvents.

Part or all of the organic solvent is preferably an organic solvent having a specific permittivity εr of 2.0 to 25.0.

The organic solvent is more preferably an organic solvent having a specific permittivity εr of 2.5 to 5.0 or 10.0 to 25.0 and still more preferably an organic solvent having a specific permittivity εr of 2.5 to 5.0 from the viewpoint of cell performance, moisture resistance, or high-humidity light resistance.

In the present invention, when a plurality of organic solvents are included, the intrinsic values of the respective organic solvents are employed as the specific permittivity of the organic solvent.

In the present invention, as the specific permittivity εr of the organic solvent, the value described in "CRC HANDBOOK OF CHEMISTRY and PHYSICS 88TH EDITION 2007-2008" (CRC PRESS) by David R. Lide is used.

For organic solvents the specific permittivity εr of which is not described in the above-described document, specific permittivity εr obtained using the following method is used.

The specific permittivity εr is measured using an impedance measurement device as a specific permittivity measurement device and a parallel plate method. In this method, an organic solvent is introduced into electrodes disposed parallel to each other, a voltage and a frequency are applied between the electrodes, thereby measuring the electric capacitance between the electrodes. The obtained electric capacitance is considered as the electric capacitance of the organic solvent. In addition, a spacer suitable for the amount of the organic solvent (volume) is inserted between the electrodes, thereby measuring the electric capacitance between the electrodes. The obtained electric capacitance is considered as the electric capacitance of the air. The specific permittivity εr of the organic solvent is computed from the following expression (X) using the electric capacitance of the organic solvent and the electric capacitance of the air obtained in the above-described manner. The specific permittivity εr varies depending on the measurement temperature, but the measurement temperature is set to 15°C to 30°C. As the specific permittivity measurement device, an Agilent 4284A precision LCr meter (trade name, manufactured by Agilent Technologies Japan, Ltd.) and measurement electrodes (16452A trade name, manufactured by Agilent Technologies Japan, Ltd.) are used.

$$\text{Expression (X): } \varepsilon r = C_p/C_o$$

$C_p$: the electric capacitance of the organic solvent, $C_o$: the electric capacitance of the air

The boiling temperature of the organic solvent is not particularly limited, but is preferably 50°C to 250°C, more preferably 80°C to 200°C, and still more preferably 80°C to 160°C. When the boiling point is in a range of 50°C to 250°C, it becomes easy to set the content of the organic solvent in the above-described range. Particularly, when the boiling point is in a range of 80°C to 160°C, it is possible to leave the organic solvent in a content in the above-described range without employing excessive drying conditions.

Preferred examples of the organic solvent include aromatic solvents such as toluene (specific permittivity εr: 2.4, boiling point: 111 °C), m-xylene (specific permittivity εr: 2.4, boiling point: 139°C), and o-xylene (specific permittivity εr: 2.6, boiling point: 145°C), halogen solvents such as chlorobenzene (specific permittivity εr: 5.7, boiling point: 132°C), o-dichlorobenzene (specific permittivity εr: 10.1, boiling point: 180°C), and 1,2-dichloroethane (specific permittivity εr: 10.4, boiling point: 84°C), nitrile solvents such as benzonitrile (specific permittivity εr: 25.9, boiling point: 191°C), amide solvents such as N,N-dimethylacetamide (specific permittivity εr: 38.9, boiling point: 165°C) and N,N-dimethylformamide (specific permittivity εr: 38.3, boiling point: 153°C), sulphur-containing solvents such as thiophene (specific permittivity εr: 2.6, boiling point: 84°C) and dimethyl sulfoxide (specific permittivity εr: 47.2, boiling point: 189°C), ether solvents such as anisole (specific permittivity εr: 4.3, boiling point: 154°C), ethoxybenzene (specific permittivity εr: 4.2, boiling point: 170°C), tetrahydrofuran (THF, specific permittivity εr: 7.5, boiling point: 65°C), 1,4-dioxane (specific permittivity εr: 2.2, boiling point: 102°C), dibutyl ether (specific permittivity εr: 3.1, boiling point: 140°C), and diethoxyethane (specific permittivity εr: 3.9, boiling point: 121 °C), nitrogen-containing heterocyclic solvents such as pyridine (specific permittivity εr: 13.3, boiling point: 115°C) and 2,6-dimethylpyridine (specific permittivity εr: 7.3, boiling point: 144°C), ketone solvents such as acetophenone (specific permittivity εr: 17.4, boiling point: 202°C), and ester solvents such as butyl acetate (specific permittivity εr: 5.1, boiling point: 126°C), methyl benzoate (specific permittivity εr: 6.6, boiling point: 199°C), and diethyl carbonate (specific permittivity εr: 2.8, boiling point: 126°C).

Among these, the ether solvents are more preferred, and anisole, ethoxybenzene, diethoxyethane, dibutyl ether, and the like are still more preferred.

In a case in which an organic solvent having a specific permittivity εr outside a range of 2.0 to 25.0 is included as the organic solvent, the ratio (volume ratio) between the organic solvent having a specific permittivity εr of 2.0 to 25.0 and the organic solvent having a specific permittivity εr outside the above-described range is preferably 1,000:1 to 10:1.

The content of the organic solvent is obtained by eluting the hole transport layer in the photoelectric conversion element with a predetermined amount of N,N-dimethylformamide (DMF) and converting a measurement value obtained by analyzing this eluate by means of gas chromatography to the content per cubic millimeter of the hole transport layer.

Specifically, first, the volume of the hole transport layer in the photoelectric conversion element is obtained. Three spots on an arbitrary cross section of the photoelectric conversion element 10 are observed using a scanning electron microscope (SEM), and individual measurement values are averaged, thereby obtaining a film thickness of the hole transport layer.

In addition, the surface area of the hole transport layer in the photoelectric conversion element 10 is measured.

The volume of the hole transport layer is obtained from the obtained film thickness and surface area.

Next, the photoelectric conversion element or a solar cell is disassembled, thereby exposing part of the hole transport layer. In this state, the photoelectric conversion element is immersed in DMF (temperature: 25°C) which is set to be used in an amount of 5 mL per a surface area of 625 $mm^2$ (for example, 25 mmx25 mm) of the hole transport layer, and the hole transport layer is eluted into an ultrasonic washing machine for one hour. The obtained DMF liquid is filtered with a filter, the filtrate is measured by means of gas chromatography, and the contents of individual organic solvents are obtained on the basis of separately-produced calibration curves. These contents are summed, thereby obtaining the total content of the organic solvents.

The total content obtained in the above-described manner is divided by the volume ($mm^3$) of the hole transport layer, thereby obtaining the content of the organic solvent per cubic millimeter of the hole transport layer.

Meanwhile, the types of organic solvents can be confirmed and identified from the holding times.

Hereinafter, the measurement conditions of the gas chromatography will be described.

As the device, GC-2010 plus (trade name, manufactured by Shimadzu Corporation) is used. The column is not particularly limited, but Agilent JW DB-624 (trade name, manufactured by Agilent Technologies Japan, Ltd., 60 m×0.32 mm×1.8 μm, component No. 123-1364) is preferably used. As the detector, a hydrogen flame ionization detector (model No. FID-2010 Plus, manufactured by Shimadzu Corporation) is used.

The detection temperature is set to 260°C. The injection mode is a split mode, and the vaporizing chamber temperature is set to 200°C to 300°C. As the carrier gas, helium is used, and the pressure is set to 90 kPa. The oven temperature is set to 40°C.

In the present invention, there are cases in which DMF which is the above-described elution solvent is also included as the organic solvent. In this case, the content of the organic solvent is a value obtained by summing the content of DMF with the content obtained from the above-described measurement. The content of DMF can be measured in the same manner as in the above-described measurement in which DMF is used except for the fact that, in the above-described measurement method in which DMF is used, an elution solvent other than DMF, for example, N,N-dimethylacetamide (DMAc) is used in the same amount as that of DMF instead of DMF.

Meanwhile, in the above-described method, part or all of the photosensitive layer also elutes. However, the amount of the organic solvent in the photosensitive layer is considered to be zero or, even when included, too small to affect measurement values. Therefore, in the present invention, values obtained using the above-described method are considered as the amount of the organic solvent in the hole transport layer.

The reasons for cell performance, moisture resistance, and high-humidity light resistance being excellent when the photoelectric conversion element and the solar cell of the present invention include the organic solvent in the content in the above-described range are not certain, but are considered as below.

When the hole transport layer includes a certain amount of the organic solvent, the hole transport layer includes only a small number of defects in the layer structure. As a result, it is considered that the fluctuation of the photoelectric conversion efficiency can be decreased.

The hole transport layer is formed by applying a hole-transporting material solution described below and then, preferably, drying the hole-transporting material solution by means of heating or the like. At this time, when the hole-transporting material solution is excessively dried, defects are generated in the layer structure of the hole transport layer to be obtained. On the other hand, when the hole-transporting material solution is not sufficiently dried, the mobility of the hole-transporting material in the hole transport layer increases, and it becomes impossible to suppress changes of the layer structure during manufacturing and over time. In both cases, the layer structure of the hole transport layer is not stable, and thus the charge-transporting properties of the hole transport layer degrade, and the photoelectric conversion efficiency fluctuates.

The present invention has been completed by discovering the fact that, as the condition of drying, the content of the organic solvent can be used as one of indexes. Specifically, it was found that, when the content of the organic

solvent is set to less than $1\times10^{-10}$ mol, the hole-transporting material solution is dried more than necessary, and, on the other hand, when the content of the organic solvent exceeds $1\times10^{-7}$ mol, the hole-transporting material solution is not sufficiently dried.

In addition, when a certain amount of the organic solvent is added to the hole transport layer, it is possible to suppress the decomposition of the perovskite compound due to water, and consequently, the moisture resistance is considered to improve.

The hole transport layer is preferably provided adjacent to the photosensitive layer, and, in this case, there are cases in which water in the hole transport layer intrudes into the photosensitive layer. Therefore, the hole transport layer preferably does not include water. However, when defects are generated in the layer structure of the hole transport layer due to the above-described excess drying, water is likely to intrude into the hole transport layer. in addition, when the content of the organic solvent in the hole transport layer is too high, the layer structure of the hole transport layer becomes dense, and, similarly, water is likely to intrude into the hole transport layer. In both cases, water which has intruded into the hole transport layer also intrudes into the photosensitive layer, and thus the perovskite compound in the photosensitive layer decomposes. As a result, the photoelectric conversion efficiency decreases.

Furthermore, the decomposition of the perovskite compound due to water is also further accelerated by light.

However, in the present invention, it is considered that the organic solvent is included in the hole transport layer and the intrusion of water into the photosensitive layer can be suppressed. That is, in a case in which the organic solvent is highly hydrophobic, the affinity to water decreases, and the intrusion of water into the hole transport layer can be suppressed. Therefore, it is considered that the decomposition of the perovskite compound in the photosensitive layer can be suppressed. On the other hand, in a case in which the organic solvent is highly hydrophilic, the water is trapped by the organic solvent due to its high hydrophilicity even when water intrudes into the hole transport layer.

From the viewpoint of suppressing the intrusion of water into the hole transport layer and the photosensitive layer, the organic solvent is preferably highly hydrophobic, and specifically, organic solvents having a specific permittivity in the above-described range are preferred.

Hereinafter, preferred aspects of the photoelectric conversion element of the present invention will be described.

In Figs. 1 to 3, the same reference symbol indicates the same constituent element (member).

Meanwhile, in Figs. 1 and 2, fine particles forming a porous layer 12 are illustrated in an enlarged manner.

These fine particles are preferably jammed with each other (accumulated or in close contact with each other) in the horizontal direction and the vertical direction with respect to a conductive support 11 and thus form a porous structure.

In the present specification, in the case of being simply mentioned, a "photoelectric conversion element 10" refers to photoelectric conversion elements 10A, 10B, and 10C unless particularly otherwise mentioned. This also shall apply to a system 100, a first electrode 1, and a photosensitive layer 13. In addition, in the case of being simply mentioned, a "hole transport layer 3" refers to hole transport layers 3A and 3B unless particularly otherwise mentioned.

Examples of the preferred aspects of the photoelectric conversion element of the present invention include the photoelectric conversion element 10A illustrated in Fig. 1. A system 100A illustrated in Fig. 1 is a system to which the photoelectric conversion element 10A is applied as a cell that causes action means M (for example, an electric motor) to operate through an external circuit 6.

The photoelectric conversion element 10A includes a first electrode 1A, a second electrode 2, and the hole transport layer 3A between the first electrode 1A and the second electrode 2.

The first electrode 1A includes the conductive support 11 made up of a support 11a and a transparent electrode 11b, the porous layer 12, and the photosensitive layer 13A on the porous layer 12. In addition, a blocking layer 14 is provided on the transparent electrode 11b, and the porous layer 12 is formed on the blocking layer 14. In the photoelectric conversion element 10A including the porous layer 12 as described above, since the surface area of the photosensitive layer 13A increases, it is assumed that the charge separation and charge transfer efficiency improves.

The photoelectric conversion element 10B illustrated in Fig. 2 is a schematic illustration of a preferred aspect in which the photosensitive layer 13A in the photoelectric conversion element 10A illustrated in Fig. 1 is provided to be thick. In this photoelectric conversion element 10B, the hole transport layer 3B is provided to be thin. The photoelectric conversion element 10B is different from the photoelectric conversion element 10A illustrated in Fig. 1 in terms of the film thicknesses of the photosensitive layer 13B and the hole transport layer 3B and is constituted in the same manner as the photoelectric conversion element 10A except for the film thicknesses.

The photoelectric conversion element 10C illustrated in Fig. 3 is a schematic illustration of another preferred aspect of the photoelectric conversion element of the present invention. The photoelectric conversion element 10C is different from the photoelectric conversion element 10B illustrated in Fig. 2 in terms of the porous layer 12 being not provided and is constituted in the same manner as the photoelectric conversion element 10B except for the porous layer. In the photoelectric conversion element 10C, the photosensitive layer 13C is formed on the surface of the blocking layer 14 in a thick film shape.

In the present invention, the system 100 to which the photoelectric conversion element 10 is applied functions

as a solar cell in the following manner.

That is, in the photoelectric conversion element 10, light that has passed through the conductive support 11 or the second electrode 2 and has entered the photosensitive layer 13 excites a light absorber. The excited light absorber has high-energy electrons and is capable of emitting the electrons. The light absorber which has emitted high-energy electrons turns into an oxidant.

Electrons emitted from the light absorber migrate in the light absorber and reach the conductive support 11. Electrons which has reached the conductive support 11 do their work in the external circuit 6 and then return to the photosensitive layer 13 through the second electrode 2 and then the hole transport layer 3. The light absorber is reduced by the electrons which have returned to the photosensitive layer 13. The system 100 functions as a solar cell by repeating the cycle of the above-described excitation of the light absorber and electron migration.

The flow direction of electrons from the photosensitive layer 13 to the conductive support 11 varies depending on the presence or absence, kind, and the like of the porous layer 12. In the photoelectric conversion element 10, electron conduction in which electrons migrate between perovskite compounds occurs. Therefore, in a case in which the porous layer 12 is provided, the porous layer 12 can be formed of an insulating body other than semiconductors in the related art. In a case in which the porous layer 12 is formed of a semiconductor, electron conduction in which electrons migrate inside or between semiconductor fine particles in the porous layer 12 also occurs. On the other hand, in a case in which the porous layer 12 is formed of an insulating body, electron conduction in the porous layer 12 does not occur. In a case in which the porous layer 12 is formed of an insulating body, when aluminum oxide ($Al_2O_3$) fine particles are used as insulating body fine particles, a relatively high electromotive force (Voc) is obtained.

In a case in which the blocking layer 14, as other layers, is formed of a conductor or a semiconductor as well, electron conduction occurs in the blocking layer 14.

In addition, in a case in which the electron transport layer is provided between the conductive support 11 and the photosensitive layer 13, electron conduction also occurs in this electron transport layer.

The photoelectric conversion element and the solar cell of the present invention are not limited to the above-described preferred aspects, and the constitutions and the like of the respective aspects can be appropriately combined together within the scope of the gist of the present invention.

In the present invention, materials and the respective members which are used in the photoelectric conversion element and the solar cell can be prepared using ordinary methods except for the light absorber and the hole transport layer. Regarding photoelectric conversion elements or solar cells in which a perovskite compound is used, it is possible to refer to, for example, WO2014/045021A and Journal of the American Chemical Society, 2014, 136, pp. 7,837 to 7,840. In addition, regarding dye sensitized solar cells, it is possible to refer to, for example, JP2001-291534A, the specification of US4927721A, the specification of US4684537A, the specification of US5084365A, the specification of US5350644A, the specification of US5463057A, the specification of US5525440A, JP1995-249790A (JP-H7-249790A), JP2004-220974A, and JP2008-135197A.

Hereinafter, preferred aspects of the main members and compounds of the photoelectric conversion element and the solar cell of the present invention will be described.

<First electrode 1>

The first electrode 1 includes the conductive support 11 and the photosensitive layer 13 and functions as a working electrode in the photoelectric conversion element 10.

The first electrode 1 preferably includes either or both the porous layer 12 and the blocking layer 14. The first electrode 1 preferably includes at least the blocking layer 14 in terms of short circuit prevention and more preferably includes the porous layer 12 and the blocking layer 14 in terms of light absorption efficiency and short circuit prevention.

- Conductive support 11 -

The conductive support 11 is not particularly limited as long as the conductive support is conductive and is capable of supporting the photosensitive layer 13 or the like. The conductive support 11 preferably has a constitution in which the conductive support is formed of a conductive material, for example, metal or a constitution in which the glass or plastic support 11a and the transparent electrode 11 b formed on the surface of the support 11a as a conductive film are provided.

In a case in which the strength of the conductive support 11 is sufficiently maintained, the support 11a is not essentially required.

Among these, the conductive support 11 in which the transparent electrode 11b is formed by applying a conductive metallic oxide onto the surface of the glass or plastic support 11a as illustrated in Figs. 1 to 3 is more preferred. Examples of the support 11a formed of plastic include transparent polymer films described in Paragraph 0153 of JP2001-291534A. As a material used to form the support 11a, it is possible to use, in addition to glass or plastic, ceramics

(JP2005-135902A) or conductive resins (JP2001-160425A). The conductive metallic oxide is preferably tin oxide (TO) and particularly preferably an indium-tin oxide (a tin-doped indium oxide, ITO) or a fluorine-doped tin oxide such as a fluorine-doped tin oxide (FTO). At this time, the amount of the metallic oxide applied is preferably in a range of 0.1 to 100 g per the surface area of the support 11 a of square meter. In a case in which the conductive support 11 is used, light preferably enters the conductive support through the support 11 a side.

The conductive support 11 is preferably substantially transparent. In the present invention, "being substantially transparent" means that the transmittance of light (having a wavelength in a range of 300 to 1,200 nm) is 10% or higher, preferably 50% or higher, and particularly preferably 80% or higher.

The thicknesses of the support 11 a and the conductive support 11 are not particularly limited and are set to appropriate thicknesses. For example, the thicknesses are preferably in a range of 0.01 μm to 10 mm, more preferably in a range of 0.1 μm to 5 mm, and particularly preferably in a range of 0.3 μm to 4 mm.

In a case in which the transparent electrode 11b is provided, the film thickness of the transparent electrode 11b is not particularly limited and is, for example, preferably in a range of 0.01 to 30 μm, more preferably in a range of 0.03 to 25 μm, and particularly preferably in a range of 0.05 to 20 μm.

The conductive support 11 or the support 11a may have a light management function on the surface. For example, the conductive support 11 or the support 11a may have on the surface an antireflection film obtained by alternately laminating high-refractive index films and low-refractive index oxide films which is described in JP2003-123859A or may have a light guide function described in JP2002-260746A.

- Blocking layer 14 -

In the present invention, the blocking layer 14 is preferably provided on the surface of the transparent electrode 11b, that is, between the conductive support 11 and the porous layer 12, the photosensitive layer 13, the hole transport layer 3, or the like.

In the photoelectric conversion element and the solar cell, for example, when the photosensitive layer 13 or the hole transport layer 3 and the transparent electrode 11b or the like are electrically brought into contact with each other, reverse currents are generated. The blocking layer 14 performs a function of preventing these reverse currents. The blocking layer 14 is also referred to as a short circuit prevention layer.

The blocking layer 14 may also be provided in a case in which the photoelectric conversion element includes an electron transport layer.

A material used to form the blocking layer 14 is not particularly limited as long as the material is capable of performing the above-described function, but is preferably a substance transmitting visible light and an insulating substance with respect to the conductive support 11 (the transparent electrode 11b) and the like. The "insulating substance with respect to the conductive support 11 (the transparent electrode 11b)" specifically refers to a compound having an energy level of the conduction band which is equal to or higher than the energy level of the conduction band of a material or the like used to form the conductive support 11 (a metallic oxide used to form the transparent electrode 11b) and is lower than the energy level of the conduction band of a material constituting the porous layer 12 or the ground state of the light absorber (n-type semiconductor compound).

Examples of a material used to form the blocking layer 14 include silicon oxide, magnesium oxide, aluminum oxide, calcium carbonate, cesium carbonate, polyvinyl alcohols, polyurethanes, and the like. In addition, the material may be a material that is ordinarily used as a photoelectric conversion material, and examples thereof include titanium oxide, tin oxide, zinc oxide, niobium oxide, tungsten oxide, and the like. Among these, titanium oxide, tin oxide, magnesium oxide, aluminum oxide, and the like are preferred.

The film thickness of the blocking layer 14 is preferably in a range of 0.001 to 10 μm, more preferably in a range of 0.005 to 1 μm, and particularly preferably in a range of 0.01 to 0.1 μm.

In the present invention, the film thicknesses of the respective layers can be measured by observing cross sections of the photoelectric conversion element 10 using a scanning electron microscope (SEM) or the like.

- Porous layer 12 -

In the present invention, as in the photoelectric conversion elements 10A and 10B, the porous layer 12 is preferably provided on the transparent electrode 11b. In a case in which the photoelectric conversion element includes the blocking layer 14, the porous layer 12 is preferably formed on the blocking layer 14.

The porous layer 12 is a layer that functions as a scaffold for carrying the photosensitive layer 13 on the surface. In solar cells, in order to increase the light absorption efficiency, it is preferable to increase the surface area of at least a portion receiving light such as sunlight, and it is preferable to increase the surface area of the porous layer 12 as a whole.

The porous layer 12 is preferably a fine particle layer having pores which is formed of fine particles of a material used to form the porous layer 12 being accumulated or in close contact with each other. The porous layer 12 may be a

fine particle layer formed of two or more kinds of many fine particles being accumulated together. When the porous layer 12 is a fine particle layer having pores, it is possible to increase the amount of the light absorber carried (adsorption amount).

In order to increase the surface area of the porous layer 12, it is preferable to increase the surface area of individual fine particles that constitute the porous layer 12. In the present invention, the surface area of fine particles used to form the porous layer 12 in a state in which the fine particles are applied onto the conductive support 11 and the like is preferably 10 or more times and more preferably 100 or more times the projected area. The upper limit thereof is not particularly limited, but is, generally, approximately 5,000 times. Regarding the particle diameters of the fine particles used to form the porous layer 12, the average particle diameter of the diameters of equivalent circles of the projected areas is preferably in a range of 0.001 to 1 μm as the primary particles. In a case in which the porous layer 12 is formed using a dispersion of the fine particles, the average particle diameter of the fine particles is preferably in a range of 0.01 to 100 μm in terms of the average particle diameter in the dispersion.

For the material used to form the porous layer 12, there is no particular limitation regarding conductivity, and thus the material may be an insulating body (insulating material), a conductive material, or a semiconductor (semi-conductive material).

As the material used to form the porous layer 12, it is possible to use, for example, chalcogenides (for example, oxides, sulfides, selenides, and the like) of metal, perovskite compounds (except for light absorbers described below), oxides of silicon (for example, silicon dioxide and zeolite), or carbon nanotubes (including carbon nanowires, carbon nanorods, and the like).

The chalcogenides of metal are not particularly limited, and preferred examples thereof include individual oxides of titanium, tin, zinc, tungsten, zirconium, hafnium, strontium, indium, cerium, yttrium, lanthanum, vanadium, niobium, aluminum, or tantalum, cadmium sulfide, cadmium selenide, and the like. Examples of the crystal structure of the chalcogenides of metal include an anatase-type crystal structure, a brookite-type crystal structure, and a rutile-type crystal structure, and an anatase-type crystal structure and a brookite-type crystal structure are preferred.

The perovskite compounds are not particularly limited, and examples thereof include transition metal oxides and the like. Examples thereof include strontium titanate, calcium titanate, barium titanate, lead titanate, barium zirconate, barium stannate, lead zirconate, strontium zirconate, strontium tantalate, potassium niobate, bismuth ferrate, barium strontium titanate, lanthanum barium titanate, calcium titanate, sodium titanate, and bismuth titanate. Among these, strontium titanate, calcium titanate, and the like are preferred.

The carbon nanotubes have a shape obtained by rolling a carbon film (graphene sheet) in a tubular shape. Carbon nanotubes are classified into single-walled carbon nanotubes (SWCNT) obtained by coiling one graphene sheet in a cylindrical shape, double-walled carbon nanotubes (DWCNT) obtained by coiling two graphene sheets in a concentric shape, and multi-walled carbon nanotubes (MWCNT) obtained by coiling multiple graphene sheets in a concentric shape. As the porous layer 12, any carbon nanotubes can be used without any particular limitation.

Among these, the material used to form the porous layer 12 is preferably an oxide of titanium, tin, zinc, zirconium, aluminum, or silicon or a carbon nanotube and more preferably titanium oxide or aluminum oxide.

The porous layer 12 may be formed of at least one of the chalcogenide of metal, the perovskite compound, the oxide of silicon, or the carbon nanotube or may be formed of a plurality thereof.

The film thickness of the porous layer 12 is not particularly limited and is generally in a range of 0.05 to 100 μm and preferably in a range of 0.1 to 100 μm, and, in the case of being used as a solar cell, the film thickness is more preferably in a range of 0.1 to 50 μm, still more preferably in a range of 0.2 to 30 μm, and particularly preferably in a range of 0.3 to 30 μm.

- Electron transport layer -

In the present invention, the electron transport layer may be provided on the surface of the transparent electrode 11b.

The electron transport layer has a function of transporting electrons generated in the photosensitive layer 13 to the conductive support 11. The electron transport layer is formed of an electron-transporting material capable of exhibiting the above-described function. The electron-transporting material is not particularly limited and is preferably an organic material (organic electron-transporting material). Examples of the organic electron-transporting material include fullerene compounds such as [6,6]-phenyl-C61-butyric acid methyl ester ($PC_{61}BM$), perylene compounds such as perylene tetracarboxylic diimide (PTCDI), additionally, low-molecular-weight compounds such as tetracyanoquinodimethane (TCNQ), high-molecular-weight compounds, and the like.

The film thickness of the electron transport layer is not particularly limited and is preferably in a range of 0.001 to 10 μm and more preferably in a range of 0.01 to 1 μm.

- Photosensitive layer (light-absorbing layer) 13 -

The photosensitive layer 13 is preferably provided on the surfaces (including the surfaces in recess portions in a case in which surfaces provided with the photosensitive layer 13 are uneven) of the respective layers of the porous layer 12 (in the photoelectric conversion elements 10A and 10B), the blocking layer 14 (in the photoelectric conversion element 10C), and the electron transport layer.
In the present invention, the light absorber needs to contain at least one perovskite compound and may contain two or more perovskite compounds.
In the present invention, the photosensitive layer 13 may contain a light absorber other than the perovskite compound. Examples of the other light absorber include metallic complex coloring agents and organic coloring agents.
The photosensitive layer 13 may be a single layer or a laminate of two or more layers. In a case in which the photosensitive layer 13 is a laminate structure of two or more layers, the laminate structure may be a laminate structure formed by laminating layers made of mutually different light absorbers or a laminate structure having an interlayer including a hole-transporting material between the photosensitive layer and the photosensitive layer.
A form of the photosensitive layer 13 being present on the conductive support 11 is as described above. The photosensitive layer 13 is preferably provided on the surface of each of the above-described layers so that excited electrons flow into the conductive support 11. At this time, the photosensitive layer 13 may be provided on the entire surface or on a part of the surface of each of the above-described layers.
The film thickness of the photosensitive layer 13 is appropriately set according to aspects of the photosensitive layer 13 provided on the conductive support 11 and is not particularly limited. The film thickness of the photosensitive layer is, for example, preferably in a range of 0.001 to 100 μm, more preferably in a range of 0.01 to 10 μm, and particularly preferably in a range of 0.01 to 5 μm.
In a case in which the porous layer 12 is provided, the total film thickness including the film thickness of the porous layer 12 is preferably 0.01 μm or more, more preferably 0.05 μm or more, still more preferably 0.1 μm or more, and particularly preferably 0.3 μm or more. In addition, the total film thickness is preferably 100 μm or less, more preferably 50 μm or less, and still more preferably 30 μm or less. The total film thickness can be set in a range obtained by appropriately combining the above-described values. For example, the total film thickness is preferably 0.1 to 100 μm, more preferably 0.1 to 50 μm, and particularly preferably 0.3 to 30 μm. Here, in a case in which the photosensitive layer 13 has a thin film shape as illustrated in Fig. 1, the film thickness of the photosensitive layer 13 refers to the distance between the interface with the porous layer 12 and the interface with the hole transport layer 3 described below in a direction perpendicular to the surface of the porous layer 12.
In the present invention, in a case in which the photosensitive layer is provided in a thick film shape (the photosensitive layers 13B and 13C), the light absorber included in the photosensitive layer also functions as a hole-transporting material.

[Light absorber]

The photosensitive layer 13 contains, as a light absorber, a perovskite compound having "an element in Group 1 of the periodic table or a cationic organic group A", "a metallic atom M that is not an element in Group 1 of the periodic table", and "an anionic atom X".
The element in Group 1 of the periodic table or cationic organic group A, the metallic atom M, and the anionic atom X in the perovskite compound are present as individual constituent ions of the cation (for convenience, in some cases, referred to as the cation A), the metallic cation (for convenience, in some cases, referred to as the cation M), and an anion (for convenience, in some cases, referred to as the anion X) respectively in the perovskite-type crystal structure.
In the present invention, the cationic organic group refers to an organic group having a property of becoming cationic in the perovskite-type crystal structure, and the anionic atom refers to an atom having a property of becoming anionic in the perovskite-type crystal structure.
In the present invention, the light absorber may include at least one perovskite compound. In this case, one perovskite compound may be used singly or two or more perovskite compounds may be jointly used.
The perovskite compound is not particularly limited as long as the perovskite compound is capable of having a perovskite-type crystal structure including the above-described constituent ions.
In the perovskite compound that is used in the present invention, the cation A is an organic cation made of a cation of an element in Group 1 of the periodic table or a cationic organic group A. The cation A is preferably an organic cation.
The cation of an element in Group 1 of the periodic table is not particularly limited, examples thereof include cations ($Li^+$, $Na^+$, $K^+$, and $Cs^+$) of individual elements of lithium (Li), sodium (Na), potassium (K), and cesium (Cs), and the cation ($Cs^+$) of cesium is particularly preferred.
The organic cation is more preferably an organic cation of a cationic organic group represented by Formula

(1) below.

Formula (1): $R^{1a}$-$NH_3$

In the formula, $R^{1a}$ represents a substituent. $R^{1a}$ is not particularly limited as long as $R^{1a}$ is an organic group, but is preferably an alkyl group, a cycloalkyl group, an alkenyl group, an alkynyl group, an aryl group, a heteroaryl group, or a group that can be represented by Formula (2) below. Among these, an alkyl group or a group that can be represented by Formula (2) below is more preferred.

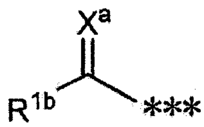

Formula (2)

In the formula, $X^a$ represents $NR^{1c}$, an oxygen atom, or a sulfur atom. $R^{1b}$ and $R^{1c}$ each independently represent a hydrogen atom or a substituent. *** represents a bonding position to the N atom in Formula (1).

In the present invention, the organic cation made of the cationic organic group A is preferably an organic ammonium cation made of an ammonium cationic organic group A which is formed by $R^{1a}$ and $NH_3$ in Formula (1) which are bonded together. In a case in which this organic ammonium cation has a resonant structure, the organic cation includes a cation having a resonant structure in addition to the organic ammonium cation. For example, in a case in which $X^a$ is NH ($R^{1c}$ represents a hydrogen atom) in a group represented by Formula (2), the organic cation includes an organic amidinium cation which is one of the resonant structures of the organic ammonium cation in addition to an organic ammonium cation of an ammonium cationic organic group formed of the group that can be represented by Formula (2) and $NH_3$ which are bonded to each other. Examples of the organic amidinium cation made of an amidinium cationic organic group include cations represented by Formula ($A^{am}$) below. Meanwhile, in the present specification, the cations represented by Formula ($A^{am}$) below will be expressed as "$R^{1b}C(=NH)-NH_3$" in some cases for convenience.

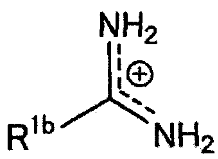

Formula ($A^{am}$)

The alkyl is preferably an alkyl group having 1 to 18 carbon atoms and more preferably an alkyl group having 1 to 6 carbon atoms. Examples thereof include methyl, ethyl, propyl, isopropyl, butyl, tert-butyl, pentyl, hexyl, and the like.

The cycloalkyl group is preferably a cycloalkyl group having 3 to 8 carbon atoms, and examples thereof include cyclopropyl, cyclopentyl, cyclohexyl, and the like.

The alkenyl group is preferably an alkenyl group having 2 to 18 carbon atoms, and examples thereof include vinyl, allyl, butenyl, hexenyl, and the like.

The alkynyl group is preferably an alkynyl group having 2 to 18 carbon atoms, and examples thereof include ethynyl, butynyl, hexynyl, and the like.

The aryl group is preferably an aryl group having 6 to 14 carbon atoms, and examples thereof include phenyl.

Examples of the heteroaryl group include groups made of an aromatic hetero ring alone and groups made of a fused hetero ring obtained by fusing a ring other than the aromatic hetero ring, for example, an aromatic ring, an aliphatic ring, or a hetero ring with the aromatic hetero ring.

A ring-constituting hetero atom constituting the aromatic hetero ring is, for example, preferably a nitrogen atom, an oxygen atom, or a sulfur atom. In addition, the number of ring members of the aromatic hetero ring is preferably five or six.

Examples of a five-membered aromatic hetero ring and a fused hetero ring including the five-membered aromatic hetero ring include individual ring groups of a pyrrole ring, an imidazole ring, a pyrazole ring, an oxazole ring, a thiazole ring, a triazole ring, a furan ring, a thiophene ring, a benzimidazole ring, a benzoxazole ring, a benzothiazole ring, an indoline ring, and an indazole ring. In addition, examples of a six-membered aromatic hetero ring and a fused hetero ring including the six-membered aromatic hetero ring include individual ring groups of a pyridine ring, a pyrimidine ring, a pyrazine ring, a triazine ring, a quinoline ring, and a quinazoline ring.

In the group that can be represented by Formula (2), $X^a$ represents $NR^{1c}$, an oxygen atom, or a sulfur atom and is preferably $NR^{1c}$. Here, $R^{1c}$ is preferably a hydrogen atom, an alkyl group, a cycloalkyl group, an alkenyl group, an alkynyl group, an aryl group, or a heteroaryl group and more preferably a hydrogen atom.

$R^{1b}$ represents a hydrogen atom or a substituent and is preferably a hydrogen atom. Examples of a substituent that can be employed by $R^{1b}$ include an alkyl group, a cycloalkyl group, an alkenyl group, an alkynyl group, an aryl group, and a heteroaryl group.

An alkyl group, a cycloalkyl group, an alkenyl group, an alkynyl group, an aryl group, and a heteroaryl group that can be respectively employed by $R^{1b}$ and $R^{1c}$ are identical to the respective groups of $R^{1a}$, and preferred groups are also identical thereto.

Examples of the group that can be represented by Formula (2) include formimidoyl (HC(=NH)-), acetoimidoyl ($CH_3C(=NH)$-), propionimidoyl ($CH_3CH_2C(=NH)$-), and the like. Among these, formimidoyl is preferred.

The alkyl group, the cycloalkyl group, the alkenyl group, the alkynyl group, the aryl group, the heteroaryl group, and the group that can be represented by Formula (2) which can be employed by $R^{1a}$ may all have a substituent. Substituents that $R^{1a}$ may have are not particularly limited, and examples thereof include an alkyl group, a cycloalkyl group, an alkenyl group, an alkynyl group, an aryl group, a heterocyclic group, an alkoxy group, an alkylthio group, an amino group, an alkylamino group, an arylamino group, an acyl group, an alkoxycarbonyl group, an aryloxycarbonyl group, an acylamino group, a sulfonamide group, a carbamoyl group, a sulfamoyl group, a halogen atom, a cyano group, a hydroxyl group, and a carboxy group. The respective substituents that $R^{1a}$ may have may be further substituted with another substituent.

In the perovskite compound that is used in the present invention, the metallic cation M is not particularly limited as long as the metallic cation is a cation of a metallic atom M that is not an element in Group 1 of the periodic table and is capable of having the perovskite-type crystal structure. Examples of the above-described metallic atoms include metallic atoms of calcium (Ca), strontium (Sr), cadmium (Cd), copper (Cu), nickel (Ni), manganese (Mn), iron (Fe), cobalt (Co), palladium (Pd), germanium (Ge), tin (Sn), lead (Pb), ytterbium (Yb), europium (Eu), indium (In), and the like. Among these, the metallic atom M is particularly preferably a Pb atom or a Sn atom. M may be one kind of metallic atom or two or more kinds of metallic atoms. In a case in which M is two or more kinds of metallic atoms, two kinds that are a Pb atom and a Sn atom are preferred. Meanwhile, the ratio between the metallic atoms at this time is not particularly limited.

In the perovskite compound that is used in the present invention, the anion X represents an anion that is an anionic atom (atomic group) X. Preferred examples of the anion include anions of halogen atoms and individual anions of $NCS^-$, $NCO^-$, $CH_3COO^-$, and $HCOO^-$. Examples of the halogen atoms include a fluorine atom, a chlorine atom, a bromine atom, an iodine atom, and the like.

The anion X may be an anion of one kind of anionic atom or an anion of two or more kinds of anionic atoms. In a case in which the anion is an anion of two or more kinds of anionic atoms, anions of two kinds of halogen atoms, particularly, an anion of a bromine atom and an anion of an iodine atom are preferred. Meanwhile, the ratio of anions in the anionic atom is not particularly limited.

The perovskite compound that is used in the present invention is preferably a perovskite compound which has the perovskite-type crystal structure including the respective constituent ions described above and is represented by Formula (I) below.

Formula (I): $A_aM_mX_x$

In the formula, A represents an element in Group 1 of the periodic table or a cationic organic group. M represents a metallic atom that is not an element in Group 1 of the periodic table.

X represents an anionic atom.
a represents 1 or 2, m represents 1, and a, m, and x satisfy $a+2m=x$.

In Formula (I), the element in Group 1 of the periodic table or the cationic organic group A forms the cation A in the perovskite-type crystal structure. Therefore, the element in Group 1 of the periodic table or the cationic organic group A is not particularly limited as long as the element in Group 1 of the periodic table or the cationic organic group A is an element or a group which turns into the cation A and is capable of constituting the perovskite-type crystal structure. The element in Group 1 of the periodic table or the cationic organic group A is identical to the element in Group 1 of the periodic table or the cationic organic group described in the section of the cation A, and preferred elements or cationic organic groups are also identical thereto.

The metallic atom M is a metallic atom forming the metallic cation M in the perovskite-type crystal structure. Therefore, the metallic atom M is an atom that is not an element in Group 1 of the periodic table and is not particularly limited as long as the metallic atom is an atom which turns into the metallic cation M and is capable of constituting the perovskite-type crystal structure. The metallic atom M is identical to the metallic atom described in the section of the

metallic cation M, and preferred atoms are also identical thereto.

The anionic atom X forms the anion X in the perovskite-type crystal structure. Therefore, the anionic atom X is not particularly limited as long as the anionic atom X is an atom which turns into the anion X and is capable of constituting the perovskite-type crystal structure. The anionic atom X is identical to the anionic atom described in the section of the anion X, and preferred atoms are also identical thereto.

The perovskite compound represented by Formula (I) is a perovskite compound represented by Formula (I-1) below in a case in which a is 1 and a perovskite compound represented by Formula (I-2) below in a case in which a is 2.

Formula (I-1): $AMX_3$

Formula (I-2): $A_2MX_4$

In Formulae (I-1) and (1-2), A represents an element in Group I of the periodic table or a cationic organic group and is identical to A in Formula (I), and a preferred group is also identical thereto.

M represents a metallic atom that is not an element in Group 1 of the periodic table and is identical to M in Formula (I), and a preferred atom is also identical thereto.

X represents an anionic atom and is identical to X in Formula (I), and a preferred anionic atom is also identical thereto.

The perovskite compound that is used in the present invention may be any one of the compound represented by Formula (I-1) and the compound represented by Formula (I-2) or may be a mixture thereof. Therefore, in the present invention, at least one kind of the perovskite compound needs to be present as the light absorber, and it is not necessary to clearly differentiate which compound is used using the compositional formula, the molecular formula, the crystal structure, and the like.

Hereinafter, specific examples of perovskite compounds that are used in the present invention will be exemplified, but the present invention is not limited by these specific examples. In the following description, compounds represented by Formula (I-1) and compounds represented by Formula (I-2) will be separately described. However, there are cases in which, depending on synthesis conditions and the like, compound exemplified as the compounds represented by Formula (I-1) turn into the compounds represented by Formula (I-2) or a mixture of the compound represented by Formula (I-1) and the compound represented by Formula (I-2). Similarly, there are cases in which compound exemplified as the compounds represented by Formula (I-2) turn into the compounds represented by Formula (I-1) or a mixture of the compound represented by Formula (I-1) and the compound represented by Formula (I-2).

Specific examples of the compounds represented by Formula (I-1) include $CH_3NH_3PbCl_3$, $CH_3NH_3PbBr_3$, $CH_3NH_3PbI_3$, $CH_3NH_3PbBrI_2$, $CH_3NH_3PbBr_2I$, $CH_3NH_3SnBr_3$, $CH_3NH_3SnI_3$, and CH (= NH) $NH_3PbI_3$.

Specific examples of the compounds represented by Formula (I-2) include $(C_2H_5NH_3)_2PbI_4$, $(CH_2{=}CHNH_3)_2PbI_4$, $(CH{=}CNH_3)_2PbI_4$, $(n\text{-}C_3H_7NH_3)_2PbI_4$, $(n\text{-}C_4H_9NH_3)_2PbI_4$, $(C_6H_5NH_3)_2PbI_4$, $(C_6H_3F_2NH_3)_2PbI_4$, $(C_6F_5NH_3)_2PbI_4$, and $(C_4H_3SNH_3)_2PbI_4$.

Here, $C_4H_3SNH_3$ in $(C_4H_3SNH_3)_2PbI_4$ is aminothiophene.

The perovskite compound can be synthesized from $MX_2$ and AX. Examples thereof include WO2014/045021A. In addition, examples thereof also include Akihiro Kojima, Kenjiro Teshima, Yasuo Shirai, and Tsutomu Miyasaka, "Organometal Halide Perovskites as Visible-Light Sensitizers for Photovoltaic Cells", J. Am. Chem. Soc., 2009, 131 (17), pp. 6,050 and 6,051.

The amount of the light absorber used is preferably an amount in which the light absorber covers at least part of the surface on which light is incident out of the surface of the porous layer 12 or the blocking layer 14 and more preferably an amount in which the light absorber covers the entire surface.

<Hole transport layer 3>

The hole transport layer 3 is a layer which has a function of compensating for electrons in oxidized bodies of the light absorber and preferably has a liquid form. The hole transport layer 3 is provided between the photosensitive layer 13 in the first electrode 1 and the second electrode 2.

As described above, the hole transport layer 3 includes the organic solvent in a content of $1\times10^{-10}$ to $1\times10^{-7}$ mol per cubic millimeter of the hole transport layer. Therefore, the hole transport layer contributes to the improvement of the cell performance, moisture resistance, or high-humidity light resistance of the photoelectric conversion element and the solar cell.

A hole-transporting material used to form the hole transport layer 3 is not particularly limited, and examples thereof include inorganic materials such as CuI, CuNCS, and grapheme oxide (GO), organic hole-transporting materials described in, for example, Paragraphs 0209 to 0212 of JP2001-291534A, and the like. Preferred examples of the organic hole-transporting material include conductive polymers such as polythiophene (examples thereof include poly(3-hexylthiophene-2,5-diyl) and polyethylene dioxythiophene (PEDOT)), polyaniline, polypyrrole, and polysilane, spiro compounds in which two rings share a central atom having a tetrahedral structure such as C or Si, aromatic amine compounds such as triarylamine, triphenylene compounds, nitrogen-containing heterocyclic compounds, and liquid crystalline cyano compounds.

The hole-transporting material is preferably an organic hole-transporting material which can be applied in a solution form and turns into solid.

Among organic hole-transporting materials, triarylamine compounds represented by Formula (D) below are particularly preferred.

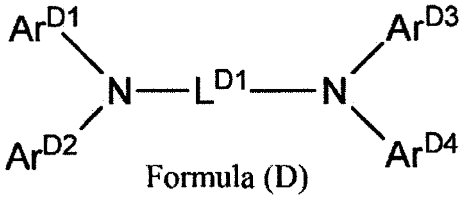

Formula (D)

In Formula (D), $L^{D1}$ represents a linking group in which at least two groups and preferably two to four groups of arylene groups, heteroarylene groups, or arylene groups and heteroarylene groups are combined to each other. $Ar^{D1}$ to $Ar^{D4}$ each individually represent an aryl group or a heteroaryl group. $Ar^{D1}$ to $Ar^{D4}$ may have a substituent. $Ar^{D1}$ and $Ar^{D2}$ or $Ar^{D3}$ and $Ar^{D4}$ may be bonded to each other and thus form a ring.

Examples of the arylene groups as $L^{D1}$ include phenylene groups and naphthylene groups, and phenylene groups are preferred.

In addition, examples of the heteroarylene groups include divalent groups of an aromatic hetero ring. The aromatic hetero ring is preferably a five-membered ring or a six-membered ring. Examples of the aromatic hetero ring serving as the heteroarylene groups include individual rings such as thiophene rings, furan rings, pyrrole rings, pyrazole rings, imidazole rings, triazole rings, oxazole rings, thiazole rings, pyridine rings, pyrazine rings, pyrimidine rings, and pyridazine rings.

The linking group in which at least two groups of arylene groups and heteroarylene groups are combined to each other as $L^{D1}$ may be a linking group in which the same type of rings are combined to each other or a linking group in which different types of rings are combined to each other. Examples of $L^{D1}$ include groups in which a plurality of arylene groups are linked to each other, groups in which a plurality of heteroarylene groups are linked to each other, and groups in which an arylene group and a heteroarylene group are linked to each other in a random or blocked manner.

Here, in a case in which the linking group is the group in which a plurality of arylene groups or heteroarylene groups are linked to each other, adjacent rings may be linked to each other and thus form a ring. The above-described ring is preferably a five-membered ring or a six-membered ring, but may be a spiro ring. Furthermore, an aromatic hydrocarbon ring or a hetero ring such as a benzene ring may be condensed to the additionally formed ring.

$L^{D1}$ is preferably a phenylene group, a group in which a plurality of phenylene groups are linked to each other, a fluorenediyl group, or a spirobifluorenediyl group.

$L^{D1}$ may also have a substituent. Examples of the substituent include an alkyl group, an alkenyl group, an alkynyl group, a cycloalkyl group, an aryl group, a heterocyclic group, an alkoxy group, an aryloxy group, an alkylthio group, an arylthio group, a hydroxyl group, an amino group, an alkylamino group, an arylamino group, a heterocyclic amino group, a halogen atom, an alkyl-substituted silyl group, an acyl group, an alkoxycarbonyl group, an aryloxycarbonyl group, an amido group, a carbamoyl group, a sulfamoyl group, and the like.

The aryl group as $Ar^{D1}$ to $Ar^{D4}$ is not particularly limited, and examples thereof include phenyl groups, naphthyl groups, and fluorenyl groups.

The heteroaryl group as $Ar^{D1}$ to $Ar^{D4}$ is preferably a monovalent group of the aromatic hetero ring which is exemplified as the heteroarylene group as $L^{D1}$, and the preferred range thereof is identical thereto.

At least one of the aryl groups or the heteroaryl groups as $Ar^{D1}$ to $Ar^{D4}$ preferably has a substituent. Examples of the substituent include an alkyl group, an alkoxy group, an alkylthio group, an alkylamino group, a dialkylamino group, an alkoxycarbonyl group, an alkylsilyl group, and an acyl group.

The compound represented by Formula (D) is preferably a compound represented by any one of Formula (D-1) and (D-2) below.

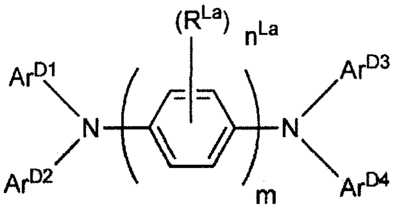

Formula (D-1)

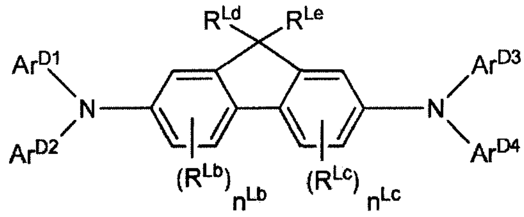

Formula (D-2)

In the formulae, $R^{La}$ to $R^{Lc}$ each independently represent a substituent. $R^{Ld}$ and $R^{Le}$ each independently represent a hydrogen atom or a substituent and are preferably a substituent. $n^{La}$'s each independently represent an integer of 0 to 4 and is preferably 0 or 1. $n^{Lb}$ and $n^{Lc}$ each independently represent an integer of 0 to 3 and is preferably 0 or 1. m represents an integer of 1 to 4 and is preferably 1 to 3. $R^{Ld}$ and $R^{Le}$ may be bonded to each other and thus form a ring.

$Ar^{D1}$ to $Ar^{D4}$ each are identical to $Ar^{D1}$ to $Ar^{D4}$ in Formula (D), and preferred examples thereof are also identical thereto. Unsubstituted phenyl groups or substituted phenyl groups are particularly preferred. Substituents substituting the phenyl group are identical to substituents that $Ar^{D1}$ to $Ar^{D4}$ in Formula (D) may have, and preferred examples thereof are also identical thereto.

$R^{La}$ to $R^{Lc}$ each are identical to substituents that $L^{D1}$ in Formula (D) may have.

$R^{Ld}$ and $R^{Le}$ each are preferably unsubstituted phenyl groups or substituted phenyl groups. $R^{Ld}$ and $R^{Le}$ are preferably bonded to each other and thus form a spiro ring.

Examples of substituents substituting the phenyl group as $R^{Ld}$ or $R^{Le}$ include substituents that $Ar^{D1}$ to $Ar^{D4}$ in Formula (D) may have and diarylamino groups. The substituents are preferably an alkyl group, an alkoxy group, or a diarylamino group and more preferably a diarylamino group having two aryl groups substituted with an alkyl group or an alkoxy group.

The compound represented by Formula (D) is more preferably a compound represented by Formula (D-2A) below.

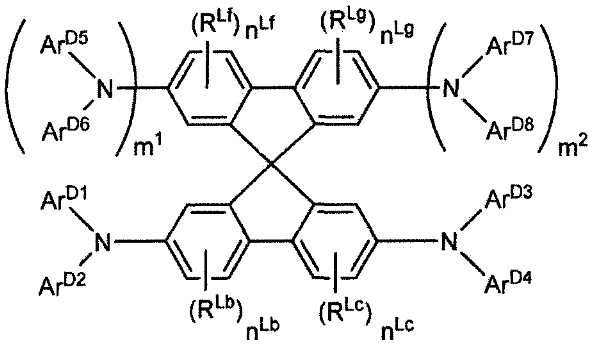

Formula (D-2A)

In the formula, $R^{Lb}$, $R^{Lc}$, $R^{Lf}$ and $R^{Lg}$ each individually represent a substituent, is identical to $R^{Lb}$ in Formula (D-2), and preferred examples thereof are also identical thereto.

$Ar^{D1}$ to $Ar^{D8}$ each are individually identical to $Ar^{D1}$ in Formula (D-2), and preferred examples thereof are also identical thereto.

$n^{Lb}$, $n^{Lc}$, $n^{Lf}$, and $n^{Lg}$ each individually represent an integer of 0 to 3 and are preferably 0 or 1.

$m^1$ and $m^2$ each individually represent 0 or 1.

Specific examples of the compound represented by Formula (D) will be described, but the compound is not limited thereto. Here, Me represents methyl.

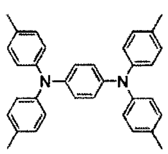

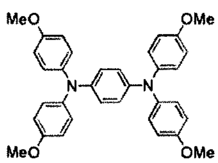

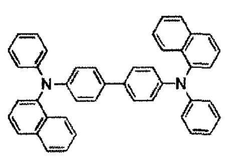

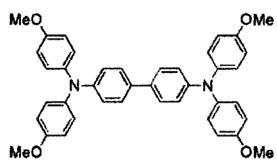

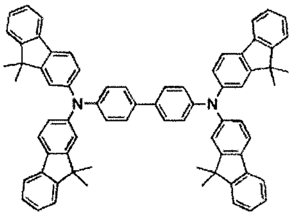

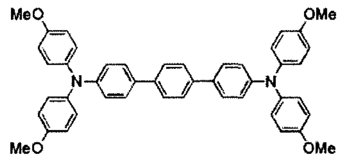

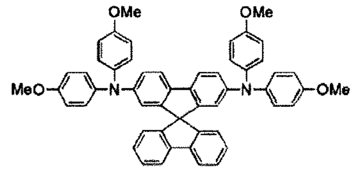

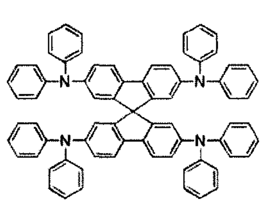

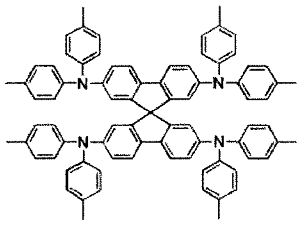

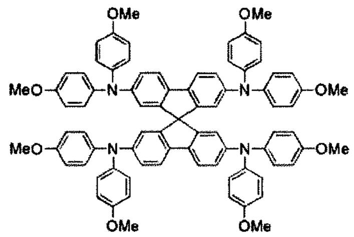

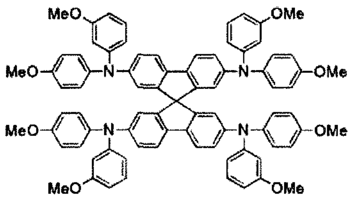

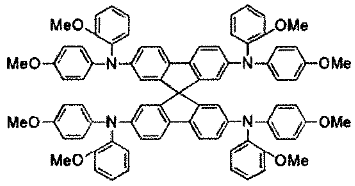

The compound represented by Formula (D) can be synthesized according to the method described in Journal of the American Chemical Society, 2014, 136, pp. 7,837 to 7,840 or Comprehensive Organic Synthesis-Selectivity, Strategy and efficiency in Modern Organic Chemistry.

The hole transport layer may further include additives that are included in hole transport layers in photoelectric conversion elements or solar cells of the related art in addition to the hole-transporting material and the organic solvent. Examples of the additives include pyridine derivatives, lithium salts, cobalt complexes, and the like. Specific examples thereof include 4-t-butylpyridine, $Li[(CF_3SO_2)_2N]$ (lithium bistrifluoromethanesulfonyl imide), and the like.

The film thickness of the hole transport layer 3 is not particularly limited, but is preferably 50 $\mu$m or less, more preferably in a range of 1 nm to 10 $\mu$m, still more preferably in a range of 5 nm to 5 $\mu$m, and particularly preferably in a range of 10 nm to 1 $\mu$m.

In the present invention, in a case in which the porous layer 12 is included, the total film thickness of the porous layer 12, the photosensitive layer 13, and the hole transport layer 3 is not particularly limited, but is, for example, preferably 0.1 to 200 $\mu$m, more preferably 0.5 to 50 $\mu$m, and still more preferably 0.5 to 5 $\mu$m.

<Second electrode 2>

The second electrode 2 functions as a positive electrode in solar cells. The second electrode 2 is not particularly limited as long as the second electrode is conductive and, generally, can be provided with the same constitution as that of the conductive support 11. The structure of the second electrode 2 is preferably a structure having a strong power-collection effect. In order to allow light to reach the photosensitive layer 13, at least one of the conductive support 11 or the second electrode 2 needs to be substantially transparent. In the solar cell of the present invention, it is preferable that the conductive support 11 is transparent and sunlight enters the solar cell through the support 11a side. In this case, the second electrode 2 more preferably has a property of reflecting light.

Examples a material used to form the second electrode 2 include metal such as platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al), the above-described conductive metallic oxides, carbon materials, conductive polymers, and the like. The carbon materials needs to be conductive materials formed of carbon atoms bonded together, and examples thereof include fullerene, carbon nanotubes, graphite, graphene, and the like.

The second electrode 2 is preferably a thin film (including a thin film obtained by means of vapor deposition) of metal or a conductive metallic oxide or a glass or plastic substrate having this thin film. The glass or plastic substrate is particularly preferably a glass substrate having a gold or platinum thin film or a glass substrate on which platinum is vapor-deposited.

The film thickness of the second electrode 2 is not particularly limited, but is preferably in a range of 0.01 to

100 μm, more preferably in a range of 0.01 to 10 μm, and particularly preferably in a range of 0.01 to 1 μm.

<Other constitutions>

In the present invention, in order to prevent the first electrode 1 and the second electrode 2 from coming into contact with each other, a spacer or a separator can also be used instead of the blocking layer 14 and the like or together with the blocking layer 14 and the like.

In addition, a hole-blocking layer may be provided between the second electrode 2 and the hole transport layer 3.

«Solar cell»

The solar cell of the present invention is constituted using the photoelectric conversion element of the present invention. For example, as illustrated in Figs. 1 to 3, it is possible to use the photoelectric conversion element 10 constituted by providing the external circuit 6 as a solar cell. As the external circuit which comes into contact with the first electrode 1 (the conductive support 11) and the second electrode 2, a well-known circuit can be used without any particularly limitation.

In order to prevent the deterioration, evaporation, and the like of constituent substances, the solar cell of the present invention preferably has a side surface that is sealed with a polymer, an adhesive, or the like.

Solar cells to which the photoelectric conversion element of the present invention is applied are not particularly limited, and examples thereof include the solar cells described in WO2014/045021A and Journal of the American Chemical Society, 2014, 136, pp. 7,837 to 7,840.

«Method for manufacturing photoelectric conversion element and solar cell»

The photoelectric conversion element and the solar cell of the present invention can be manufactured according to well-known manufacturing methods, for example, the methods described in WO2014/045021A and Journal of the American Chemical Society, 2014, 136, pp. 7,837 to 7,840.

Hereinafter, a method for manufacturing a photoelectric conversion element and a solar cell will be briefly described.

At least one of the blocking layer 14, the porous layer 12, or the electron transport layer is formed on the surface of the conductive support 11 as desired.

The blocking layer 14 can be formed by, for example, applying a dispersion including the above-described insulating substance, a precursor compound thereof, or the like onto the surface of the conductive support 11 and firing the dispersion or thermally decomposing the dispersion by means of spraying.

A material used to form the porous layer 12 is preferably used in a fine particle form and more preferably used in a form of fine particles in a dispersion.

A method for forming the porous layer 12 is not particularly limited, and examples thereof include wet-type methods, dry-type methods, and other methods (for example, methods described in Chemical Review, Vol. 110, p. 6595 (published on 2010)). In these methods, it is preferable to apply the dispersion (paste) onto the surface of the conductive support 11 or the surface of the blocking layer 14 and then fire the dispersion at a temperature in a range of 100°C to 800°C for ten minutes to ten hours, for example, in the air. In such a case, it is possible to bring the fine particles into close contact with each other.

In a case in which firing is performed multiple times, the temperature of firing that is not the final firing (the non-final firing temperature) is preferably set to be lower than the temperature of the final firing (the final firing temperature). For example, in a case in which titanium oxide paste is used, the non-final firing temperature can be set in a range of 50°C to 300°C. In addition, the final firing temperature can be set to be higher than the non-firing firing temperature in a range of 100°C to 600°C. In a case in which a glass support is used as the support 11a, the firing temperature is preferably in a range of 60°C to 500°C.

The amount of a porous material applied to form the porous layer 12 is appropriately set depending on the film thickness of the porous layer 12, the number of times of coating, and the like and is not particularly limited. The amount of the porous material applied to square meter of the surface area of the conductive support 11 is, for example, preferably in a range of 0.5 to 500 g and more preferably in a range of 5 to 100 g.

In a case in which the electron transport layer is provided, the layer can be formed in the same manner as the hole transport layer 3 described below.

Next, the photosensitive layer 13 is provided.

A method for providing the photosensitive layer 13 is not particularly limited, and examples thereof include wet-type methods and dry-type methods. In the present invention, wet-type methods are preferred, and, for example, a method in which the surface is brought into contact with a light absorber solution including the light absorber is preferred.

In this method, first, the light absorber solution for forming the photosensitive layer 13 is prepared. The light absorber solution includes $MX_2$ and AX which are raw materials of the perovskite compound. Here, A, M, and X are identical to A, M, and X in Formula (I). In this light absorber solution, the molar ratio between $MX_2$ and AX is adjusted depending on a or the like of the perovskite compound. In a case in which a perovskite compound is formed as the light absorber, the molar ratio between $MX_2$ and AX is preferably in a range of 1:1 to 10:1. The light absorber solution can be prepared by mixing $MX_2$ and AX in a predetermined molar ratio and then heating the components. This forming liquid is generally a solution, but may be a suspension. Heating conditions are not particularly limited, but the heating temperature is preferably in a range of 30°C to 200°C and more preferably in a range of 70°C to 150°C. The heating duration is preferably in a range of 0.5 to 100 hours and more preferably in a range of 1 to 3 hours. As a solvent or a dispersion medium, substances described below can be used.

Next, the prepared light absorber solution is brought into contact with the surface of the porous layer 12 or the surface of the blocking layer 14. Specifically, it is preferable to apply the light absorber solution onto the surface or immerse the surface in the forming liquid. The temperature at which the forming liquid is brought into contact with the surface is preferably in a range of 5°C to 100°C, and the immersion duration is preferably in a range of 5 seconds to 24 hours and more preferably in a range of 20 seconds to 1 hour. In a case in which the applied light absorber solution is dried, the forming liquid is preferably dried using heat and is generally dried by being generally heated at 20°C to 300°C and being preferably heat at 50°C to 170°C.

In addition, it is also possible to for the photosensitive layer according to a method for synthesizing the above-described perovskite compound.

Furthermore, examples thereof also include a method in which an AX solution including the AX and an $MX_2$ solution including the $MX_2$ are separately applied (including the immersion method) and are dried as necessary. In this method, any solution may be applied in advance, but the $MX_2$ solution is preferably applied in advance. In this method, the molar ratio between AX and $MX_2$, coating conditions, and drying conditions are identical to those in the above-described method. In this method, instead of applying the AX solution and the $MX_2$ solution, it is also possible to vapor-deposit AX or $MX_2$.

Furthermore, as another method, it is possible to use a dry-type method such as vapor deposition in a vacuum in which a compound or a mixture obtained by removing the solvent from the light absorber solution is used. For example, it is possible to use a method in which the AX and the $MX_2$ are simultaneously or sequentially vapor-deposited.

In these method and the like, the perovskite compound is formed on the surface of the porous layer 12 or the surface of the blocking layer 14 as the photosensitive layer.

On the photosensitive layer 13 provided as described above, the hole transport layer 3 is formed.

The hole transport layer 3 can be formed by applying and, preferably, drying a hole-transporting material solution including a hole-transporting material. In the hole-transporting material solution, the concentration of the hole-transporting material is preferably in a range of 0.01 to 1.0 M (mol/L) and more preferably in a range of 0.05 to 0.3 M (mol/L) since coatability is excellent and, in a case in which the porous layer 12 is provided, the hole-transporting material is capable of easily intruding into the inside of pores in the porous layer 12.

In the present invention, the method for drying the hole transport layer 3 is not particularly limited as long as the content of the organic solvent in the hole transport layer 3 is in the above-described range in the method. As the drying method, it is possible to use, for example, ordinary methods such as drying by heating, blast drying, vacuum drying, and drying by infrared heating. In the present invention, drying by heating is preferred.

Drying conditions vary depending on the organic solvent being used and thus cannot be generally determined. The drying temperature is preferably set to the boiling point or lower of the organic solvent since it is possible to uniformly maintain film qualities including no pores. The drying temperature is preferably 40°C to 180°C and more preferably 50°C to 120°C. The drying time is preferably 1 minute to 2 hours, more preferably 3 minutes to 2 hours, still more preferably 3 minutes to 30 minutes, and particularly preferably 5 minutes to 30 minutes. The drying may be carried out at normal pressure (1 atmosphere) or may be carried out at 0.7 to 1.0 atmosphere. In addition, the drying can be carried out in the atmosphere or a deoxidation atmosphere.

After the hole transport layer 3 is formed, the second electrode 2 is formed, thereby manufacturing the photoelectric conversion element and the solar cell.

The film thicknesses of the respective layers can be adjusted by appropriately changing the concentrations of the respective dispersion liquids or solutions and the number of times of coating. For example, in a case in which the photosensitive layers 13B and 13C having a thick film thickness which are illustrated in Fig. 2 or 3 are provided, the light absorber solution may be applied and dried multiple times.

The respective dispersion liquids and solutions described above may respectively include additives such as a dispersion aid and a surfactant.

Examples of the solvent or dispersion medium that is used in the method for manufacturing the photoelectric conversion element and the solar cell (except for the method for manufacturing the hole transport layer) include solvents described in JP2001-291534A, but the solvent or dispersion medium is not limited thereto. In the present invention,

organic solvents are preferred, and alcohol solvents, amide solvents, nitrile solvents, hydrocarbon solvents, lactone solvents, and solvent mixtures of two or more thereof are more preferred. The solvent mixture is preferably a solvent mixture of an alcohol solvent and a solvent selected from amide solvents, nitrile solvents, and hydrocarbon solvents. Specifically, methanol, ethanol, γ-butyrolactone, chlorobenzene, acetonitrile, N,N-dimethylformamide (DMF) or N,N-dimethylacetamide, or a solvent mixture thereof is preferred.

A method for applying the solutions or dispersants used to form the respective layers is not particularly limited, and it is possible to use a well-known coating method such as spin coating, extrusion die coating, blade coating, bar coating, screen printing, stencil printing, roll coating, curtain coating, spray coating, dip coating, an inkjet printing method, or an immersion method. Among these, spin coating, screen printing, an immersion method, and the like are preferred.

The photoelectric conversion element produced as described above can be used as a solar cell by connecting the external circuit 6 to the first electrode 1 (the transparent electrode 11b) and the second electrode 2.

## Examples

Hereinafter, the present invention will be described in more detail on the basis of examples, but the present invention is not limited thereto.

### Example 1

(Manufacturing of photoelectric conversion element (Specimen No. 101))

The photoelectric conversion element 10A illustrated in Fig. 1 were manufactured in an order described below.

<Production of conductive support 11>

A fluorine-doped SnO2 conductive film (the transparent electrode 11b, film thickness: 0.3 μm) was formed on a glass substrate (the support 11a, thickness: 2.2 mm, 25 mmx25 mm), thereby producing a conductive support 11.

<Preparation of solution for blocking layer>

An isopropanol solution containing 15% by mass of titanium diisopropoxide bis(acetylacetonate) (manufactured by Sigma-Aldrich Japan K.K.) was diluted with 1-butanol, thereby preparing 0.02 M of a solution for a blocking layer.

<Formation of blocking layer 14>

A blocking layer 14 made of titanium oxide (having a film thickness of 100 nm) was formed on the $SnO_2$ conductive film using 0.02 M of the solution for the blocking layer at 450°C by means of a spray thermal decomposition method.

<Preparation oftitanium oxide paste>

Ethyl cellulose, lauric acid, and terpineol were added to an ethanol dispersion liquid of titanium oxide (anatase, an average particle diameter of 20 nm), thereby preparing titanium oxide paste.

<Formation of porous layer 12>

The prepared titanium oxide paste was applied onto the blocking layer 14 by means of a screen printing method and was fired. The application and firing of the titanium oxide paste were carried out twice respectively. The firing temperature was 130°C in the first firing and 500°C in the second firing, and the firing time was one hour. The obtained titanium oxide fired body was immersed in an aqueous solution of 40 mM of $TiCl_4$, then, was heated at 60°C for one hour, and, continuously, was heated at 500°C for 30 minutes, thereby forming the porous layer 12 (having a film thickness of 500 nm) made of $TiO_2$.

<Formation of photosensitive layer 13A>

A 40% methanol solution of methyl amine (27.86 mL) and an aqueous solution of 57% by mass of hydrogen iodide (hydroiodic acid, 30 mL) were stirred in a flask at 0°C for two hours and then were condensed, thereby obtaining a $CH_3NH_3I$ coarse body. The obtained $CH_3NH_3I$ coarse body was dissolved in ethanol and was recrystallized with diethyl

ether. The precipitated crystals were filtered and were dried at 60°C for 24 hours under reduced pressure, thereby obtaining purified $CH_3NH_3I$.

Next, the purified $CH_3NH_3I$ and $PM_2$ were stirred and mixed together at 60°C in γ-butyrolactone for 12 hours at a molar ratio set to 2:1 and then were filtered using a polytetrafluoroethylene (PTFE) syringe filter, thereby preparing 40% by mass of a light absorber solution.

The prepared light absorber solution was applied onto the porous layer 12 using a spin coating method (at 2,000 rpm for 60 seconds and continuously at 3,000 rpm for 60 seconds), and the light absorber solution was dried at 100°C for 40 minutes using a hot plate, thereby forming a photosensitive layer (having a film thickness of approximately 600 nm (including the film thickness of a porous layer 12 which was 500 nm)) as a photosensitive layer 13A having a perovskite compound. The obtained perovskite compound was $CH_3NH_3PbI_3$.

A first electrode 1 was produced in the above-described manner.

<Preparation of hole-transporting material solution>

A hole-transporting material shown in Table 1 (180 mg) was dissolved in an organic solvent (1 mL) shown in Table 1. An acetonitrile solution (37.5 μL) obtained by dissolving lithium-bis(trifluoromethanesulfonyl)imide (170 mg) in acetonitrile (1 mL) and t-butylpyridine (TBP, 17.5 μL) were added to and mixed with the obtained solution, thereby preparing a hole-transporting material solution.

<Formation of hole transport layer 3>

Next, the prepared hole-transporting material solution was applied onto the photosensitive layer 13 in the first electrode 1 using a spin coating method (the solution was added dropwise, was then left to stand for 30 seconds, and was then spun at 500 rpm for 15 seconds). After the application, the hole-transporting material solution was dried under conditions of the temperature and the time shown in Table 1 at normal pressure on a hot plate in the atmosphere. A solid hole transport layer 3 (film thickness: approximately 200 nm) was formed in the above-described manner.

<Production of second electrode 2>

Gold was vapor-deposited on the hole transport layer 3 using a vapor deposition method, thereby producing a second electrode 2 (film thickness: 0.3 μm).

The photoelectric conversion element of the present invention was manufactured in the above-described manner.

The respective film thicknesses were measured by means of SEM observation according to the above-described method.

(Manufacturing of photoelectric conversion elements (Specimen Nos. 102 to 127 and Specimen Nos. c01 to c04))

Photoelectric conversion elements (Specimen Nos. 102 to 127 and Specimen Nos. c01 to c04) were respectively manufactured in the same manner as in the manufacturing of Specimen No. 101 except for the fact that, in the manufacturing of Specimen No. 101, the hole-transporting material solution was prepared using the hole-transporting material and the organic solvent which are shown in Table 1 and, furthermore, the hole-transporting material solution was dried under conditions of the drying temperature and the drying time shown in Table 1.

<Measurement of content of organic solvent>

The organic solvents included in the photoelectric conversion elements of the obtained specimen numbers below were identified using the above-described method and the contents thereof were measured.

The measurement conditions are as described above; however, as the elution solvent, 5 mL of DMF was used.

The organic solvents confirmed and identified in the respective specimens and the contents thereof are shown in Table 1.

Test 1: Evaluation of variation of photoelectric conversion efficiency

For each of the specimen numbers, the variation of the photoelectric conversion efficiency was evaluated in the following manner.

That is, ten test bodies of each of the photoelectric conversion elements having a different specimen number were manufactured in the same manner as in the above-described manufacturing method. After that, the obtained test

bodies were stored in a constant temperature and constant humidity tank of at a temperature of 25°C and a humidity of 45%RH for 24 hours, then, cell characteristics tests were carried out on the ten test bodies respectively, and the photoelectric conversion efficiencies (η/%) were measured. The cell characteristic tests were carried out by radiating 1,000 W/$m^2$ of simulated sunlight which had passed through an AM 1.5 filter from a xenon lamp using a solar simulator "WXS-85H" (manufactured by Wacom Electric Co., Ltd.). The current-voltage characteristics were measured using an I-V tester, and the photoelectric conversion efficiencies (η/%) were obtained.

In a case in which the photoelectric conversion efficiency of a test body exhibiting the highest photoelectric conversion efficiency out of the photoelectric conversion efficiencies of the ten test bodies obtained in the above-described manner was set to "1", the number of test bodies having a relative value of the photoelectric conversion efficiency of 0.85 or higher was investigated, and the variation of the photoelectric conversion efficiency was evaluated using the following standards. The results are shown in Table 1.

In the present test, variations of the photoelectric conversion efficiency evaluated as "A" and "B" are at pass levels. Variations evaluated as "C" and "D" are a significant variation of the photoelectric conversion efficiency and do not reach the pass level (required level) of the present test.

A: The number of the test bodies is eight or more.
B: The number of the test bodies is six or seven.
C: The number of the test bodies is three to five.
D: The number of the test bodies is two or less.

In the evaluation of the variation of the photoelectric conversion efficiency, the photoelectric conversion efficiencies of the respective photoelectric conversion elements of the present invention were high enough to make solar cells sufficiently function.

Test 2: Evaluation of moisture resistance

Out of the ten test bodies of each of the respective specimen numbers obtained, the test body exhibiting the highest conversion efficiency in Test 1 was further stored in a constant temperature and constant humidity tank of at a temperature of 85°C and a humidity of 85%RH for 24 hours, and then the photoelectric conversion efficiency after the storage was measured through the same cell characteristics test as in Test 1. The relative value of the photoelectric conversion efficiency after the storage in a case in which the photoelectric conversion efficiency of the test body before the storage was set to "1" was computed and was evaluated using the following standards. The results are shown in Table 1.

In the present test, moisture resistance evaluated as "S", "A", and "B" is at a pass level. Moisture resistance evaluated as "C" is a poor moisture resistance and does not reach the pass level (required level) of the present test.

S: The relative value is 0.8 or higher.
A: The relative value is 0.6 or higher and lower than 0.8.
B: The relative value is 0.4 or higher and lower than 0.6.
C: The relative value is lower than 0.4.

Test 3: Evaluation of high-humidity light resistance

Out of the ten test bodies of each of the respective specimen numbers obtained, four test bodies exhibiting the second to fifth highest photoelectric conversion efficiencies in Test 1 were irradiated with 1,000 W/$m^2$ of simulated sunlight which had passed through an AM 1.5 filter radiated from a xenon lamp for 24 hours in a constant temperature and constant humidity tank of at a temperature of 25°C and a humidity of 85%RH. The photoelectric conversion efficiencies after the irradiation were measured through the same cell characteristics test as in Test 1. The relative value of the average photoelectric conversion efficiency of the four test bodies of each of the respective specimen numbers after the storage in a case in which the photoelectric conversion efficiencies of the four test bodies of each of the respective specimen numbers before the irradiation were set to "1" was computed and was evaluated using the following standards. The results are shown in Table 1.

In the present test, high-humidity light resistance evaluated as "S", "A", and "B" is at a pass level. High-humidity light resistance evaluated as "C" is a poor high-humidity light resistance and does not reach the pass level (required level) of the present test.

S: The relative value is 0.7 or higher.
A: The relative value is 0.5 or higher and lower than 0.7.

B: The relative value is 0.3 or higher and lower than 0.5.

C: The relative value is lower than 0.3.

[Table 1]

| Specimen No. | Hole-transporting material | Organic solvent | Specific permittivity εr | Drying temperature (°C) | Drying time (minutes) | Content (*1) | Variation | Moisture resistance | High-humidity light resistance | Note |
|---|---|---|---|---|---|---|---|---|---|---|
| 101 | HTM-1 | Anisole | 4.3 | 60 | 10 | $2.3\times10^{-8}$ | A | S | S | Present Invention |
| 102 | HTM-1 | Ethoxybenzene | 4.2 | 70 | 10 | $3.8\times10^{-8}$ | A | S | S | Present Invention |
| 103 | HTM-1 | Diethoxyethane | 3.9 | 50 | 10 | $4.2\times10^{-8}$ | A | S | A | Present Invention |
| 104 | HTM-1 | Dibutyl ether | 3.1 | 50 | 10 | $1.7\times10^{-8}$ | A | S | A | Present Invention |
| 105 | HTM-1 | o-dichlorobenzene | 10.1 | 70 | 10 | $4.7\times10^{-8}$ | A | A | A | Present Invention |
| 106 | HTM-1 | 1,2-dichloroethane | 10.4 | 50 | 5 | $3.3\times10^{-8}$ | B | S | A | Present Invention |
| 107 | HTM-1 | Acetophenone | 17.4 | 80 | 10 | $2.9\times10^{-8}$ | B | A | S | Present Invention |
| 108 | HTM-1 | Toluene | 2.4 | 50 | 5 | $1.5\times10^{-8}$ | A | B | A | Present Invention |
| 109 | HTM-1 | Chlorobenzene | 5.7 | 50 | 10 | $2.2\times10^{-8}$ | A | B | A | Present Invention |
| 110 | HTM-1 | Methyl benzoate | 6.6 | 100 | 10 | $3.4\times10^{-8}$ | A | B | A | Present Invention |
| 111 | HTM-1 | Tetrahydrofuran | 7.5 | 50 | 5 | $4.6\times10^{-8}$ | A | B | B | Present Invention |
| 112 | HTM-1 | Benzonitrile | 25.9 | 120 | 10 | $3.8\times10^{-8}$ | B | B | A | Present Invention |
| 113 | HTM-1 | N,N-dimethylacetamide | 38.9 | 100 | 10 | $4.8\times10^{-8}$ | B | B | A | Present Invention |
| 114 | HTM-1 | Anisole | 4.3 | 120 | 60 | $2.0\times10^{-10}$ | B | A | A | Present Invention |

(continued)

| Specimen No. | Hole-transporting material | Organic solvent | Specific permittivity εr | Drying temperature (°C) | Drying time (minutes) | Content (*1) | Variation | Moisture resistance | High-humidity light resistance | Note |
|---|---|---|---|---|---|---|---|---|---|---|
| 115 | HTM-1 | Anisole | 4.3 | 60 | 30 | $1.9\times10^{-9}$ | A | A | S | Present Invention |
| 116 | HTM-1 | Anisole | 4.3 | 40 | 10 | $4.5\times10^{-8}$ | A | S | A | Present Invention |
| 117 | HTM-1 | Chlorobenzene | 5.7 | 100 | 120 | $2.4\times10^{-10}$ | B | B | B | Present Invention |
| 118 | HTM-1 | Chlorobenzene | 5.7 | 70 | 30 | $1.6\times10^{-9}$ | A | B | B | Present Invention |
| 119 | HTM-1 | Chlorobenzene | 5.7 | 50 | 3 | $4.7\times10^{-8}$ | A | B | B | Present Invention |
| 120 | HTM-1 | Toluene | 2.4 | 90 | 30 | $1.5\times10^{-10}$ | B | B | B | Present Invention |
| 121 | HTM-1 | Toluene | 2.4 | 50 | 30 | $2.1\times10^{-9}$ | A | B | B | Present Invention |
| 122 | HTM-1 | Toluene | 2.4 | 40 | 10 | $4.8\times10^{-8}$ | A | B | B | Present Invention |
| 123 | HTM-2 | Anisole | 4.3 | 60 | 10 | $1.8\times10^{-8}$ | A | S | S | Present Invention |
| 124 | HTM-2 | Diethoxyethane | 3.9 | 50 | 10 | $3.5\times10^{-8}$ | A | S | A | Present Invention |
| 125 | HTM-2 | o-dichlorobenzene | 10.1 | 70 | 10 | $4.0\times10^{-8}$ | A | A | A | Present Invention |
| 126 | HTM-1 | Methyl benzoate | 6.6 | 180 | 3 | $1.3\times10^{-10}$ | B | B | A | Present Invention |
| 127 | HTM-1 | Anisole<br>Diethoxyethane (*2) | 4.3<br>3.9 | 50 | 10 | $3.8\times10^{-8}$ | A | S | S | Present Invention |
| c01 | HTM-1 | Chlorobenzene | 5.7 | 100 | 180 | $<1.0\times10^{-10}$ | D | C | C | Comparative Example |

(continued)

| Specimen No. | Hole-transporting material | Organic solvent | Specific permittivity εr | Drying temperature (°C) | Drying time (minutes) | Content (*1) | Variation | Moisture resistance | High-humidity light resistance | Note |
|---|---|---|---|---|---|---|---|---|---|---|
| c02 | HTM-1 | Chlorobenzene | 5.7 | 40 | 3 | $2.3\times10^{-7}$ | C | C | C | Comparative Example |
| c03 | HTM-1 | Toluene | 2.4 | 90 | 120 | $<1.0\times10^{-10}$ | D | C | C | Comparative Example |
| c04 | HTM-1 | Toluene | 2.4 | 40 | 1 | $2.1\times10^{-7}$ | C | C | C | Comparative Example |

(*1) "Content" refers to the content of the organic solvent, and the unit is mol/(cubic millimeter of the hole transport layer).
(*2) The mixing ratio (volume ratio) between anisole and diethoxyethane was set to 1:1.

HTM-1 and HTM-2 shown in Table 1 refer to compounds having the following structure.

HTM-1 was synthesized on the basis of the method described in Journal of the American Chemical Society, 2014, 136, pp. 7,837 to 7,840.

HTM-2 was synthesized on the basis of the method described in Journal of the American Chemical Society, 2014, 136, pp. 7,837 to 7,840 except for the fact that 2,7-dibromo-9,9'-spirobi[9H-fluorene] was used as a raw material.

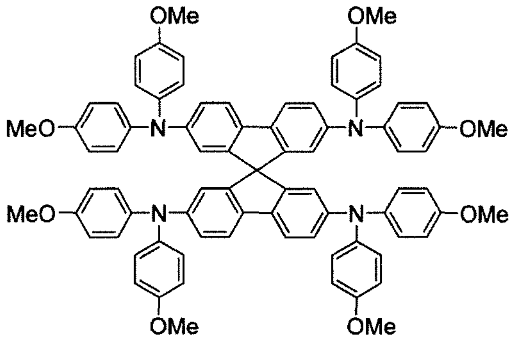

spiro-OMeTAD : HTM-1

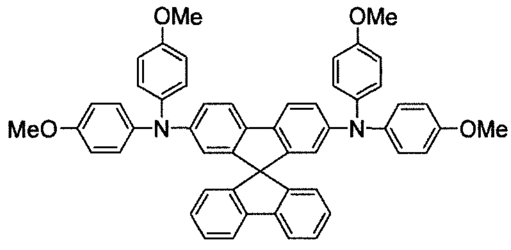

spiro-OMeTPD : HTM-2

The following fact is clear from Table 1.

In the photoelectric conversion elements of Specimen Nos. 101 to 127, the variation of the photoelectric conversion efficiency was decreased, and the moisture resistance and the high-humidity light resistance were also excellent.

For photoelectric conversion elements including a hole transport layer in which HTM-1 was used as the hole-transporting material and the content of the organic solvent was in a range of $1.5\times10^{-8}$ to $4.8\times10^{-8}$ mol/l $mm^3$, the following facts are found. That is, in a case in which the organic solvent had a specific permittivity εr of 2.5 to 5.0 (Specimen Nos. 101 to 104), the photoelectric conversion elements had the variation of the photoelectric conversion efficiency, the moisture resistance, and the high-humidity light resistance in a highly-balanced manner. Particularly, the moisture resistance and the high-humidity light resistance were excellent. The same results as described above were also obtained in a case in which two types of the organic solvents all had a specific permittivity εr of 2.5 to 5.0 (Specimen No. 127). In a case in which the organic solvent had a specific permittivity εr of 10.0 to 25.0 (Specimen Nos. 105 to 107), the photoelectric conversion elements were excellent in terms of all of the variation of the photoelectric conversion efficiency, the moisture resistance, and the high-humidity light resistance. In a case in which the organic solvent had a specific permittivity εr of lower than 2.5 and 5.0 to 10.0 (Specimen Nos. 108 to 111), the variation of the photoelectric conversion efficiency, the moisture resistance, and the high-humidity light resistance of the photoelectric conversion elements were all at the pass levels, and, particularly, the variation of the photoelectric conversion efficiency was excellent. In a case in which the organic solvent had a specific permittivity εr of higher than 25 (Specimen Nos. 112 and 113), the variation of the photoelectric conversion efficiency, the moisture resistance, and the high-humidity light resistance of the photoelectric conversion elements were all at the pass levels.

In addition, when the organic solvent was an ether solvent such as anisole, ethoxybenzene, diethoxyethane, or dibutyl ether (Specimen Nos. 101 to 104 and 127), the photoelectric conversion elements had the variation of the photoelectric conversion efficiency, the moisture resistance, and the high-humidity light resistance in a highly-balanced manner.

In a case in which the content of the organic solvent was changed by changing the drying conditions of the hole-transporting material solution (Specimen Nos. 114 to 122 and 126) and a case in which the hole-transporting material was changed (Specimen Nos. 123 to 125) as well, when the content of the organic solvent was in a predetermined range, the variation of the photoelectric conversion efficiency, the moisture resistance, and the high-humidity light resistance were all at the pass levels.

In contrast, in Comparative Examples c01 to c04 in which the content of the organic solvent was outside the range determined by the present invention, the variation of the photoelectric conversion efficiency was huge, and furthermore, the moisture resistance and the high-humidity light resistance were all deteriorated.

The above-described results indicate that the photoelectric conversion element of the present invention and the solar cell for which the photoelectric conversion element is used have a photoelectric conversion efficiency that does not significantly fluctuate, is capable of exhibiting stable cell performance, and, furthermore, has excellent moisture resistance and high-humidity light resistance.

Example 2

Photoelectric conversion elements 10A were manufactured in the same manner as in the manufacturing of the photoelectric conversion element of Example 1 except for the fact that, in the manufacturing of the photoelectric conversion element of Example 1, a light absorber solution prepared by changing the molar ratio between $CH_3NH_3I$ and $PbI_2$ to 3:1 was used. The obtained perovskite compound included $(CH_3NH_3)_2PbI_4$. As a result of evaluating the obtained photoelectric conversion elements by means of Tests 1 to 3 in the same manner as in Example 1, all of the photoelectric conversion elements obtained excellent results in the same manner as the respective conversion elements of Specimen Nos. 101 to 127.

The present invention has been described together with embodiments thereof, but the present inventors do not limit the present invention in any detailed part of the description unless particularly otherwise described and consider that the present invention is supposed to be widely interpreted within the scope of the concept of the present invention which is described in the accompanying claims.

The present application claims priority on the basis of JP2014-236632, filed on November 21, 2014, the content of which is incorporated herein by reference.

Explanation of References

1A, 1B, 1C: first electrode
11: conductive support
11a: support
11b: transparent electrode
12: porous layer
13A, 13B, 13C: photosensitive layer
14: blocking layer
2: second electrode
3A, 3B: hole transport layer
6: external circuit (lead)
10A, 10B, 10C: photoelectric conversion element
100A, 100B, 100C: system in which photoelectric conversion element is applied to cell use
M: electric motor

**Claims**

**1.** A photoelectric conversion element comprising:

a first electrode having a photosensitive layer including a light absorber on a conductive support;
a second electrode facing the first electrode; and
a hole transport layer provided between the first electrode and the second electrode,
wherein the light absorber includes a compound having a perovskite-type crystal structure having a cation of an element in Group 1 of the periodic table or a cationic organic group A, a cation of a metallic atom M that is not an element in Group 1 of the periodic table, and an anion that is an anionic atom X, and
a content of an organic solvent per cubic millimeter of the hole transport layer is $1\times10^{-10}$ to $1\times10^{-7}$ mol.

**2.** The photoelectric conversion element according to claim 1,
wherein the organic solvent is an organic solvent having a specific permittivity of 2.0 to 25.0.

**3.** The photoelectric conversion element according to claim 2,
wherein the organic solvent is an organic solvent having a specific permittivity of 2.5 to 5.0 or 10.0 to 25.0.

**4.** The photoelectric conversion element according to claim 2 or 3,
wherein the organic solvent is an organic solvent having a specific permittivity of 2.5 to 5.0.

**5.** The photoelectric conversion element according to any one of claims 1 to 4,
wherein the content of the organic solvent per cubic millimeter of the hole transport layer is $1\times10^{-9}$ to $5\times10^{-8}$ mol.

**6.** The photoelectric conversion element according to any one of claims 1 to 5, wherein the hole transport layer is formed by means of coating.

**7.** The photoelectric conversion element according to claim 6, wherein the hole transport layer is dried at 40°C to 180°C.

**8.** A solar cell comprising:

the photoelectric conversion element according to any one of claims 1 to 7.

**9.** A method for manufacturing a photoelectric conversion element including a first electrode having a photosensitive layer including a light absorber on a conductive support, a second electrode facing the first electrode, and a hole transport layer provided between the first electrode and the second electrode, in which the light absorber includes a compound having a perovskite-type crystal structure having a cation of an element in Group 1 of the periodic table or a cationic organic group A, a cation of a metallic atom M that is not an element in Group 1 of the periodic table, and an anion that is an anionic atom X, comprising at least:

a step of applying a hole-transporting material solution including a hole-transporting material and an organic solvent onto the first electrode and drying the hole-transporting material solution at 40°C to 180°C.

FIG. 1

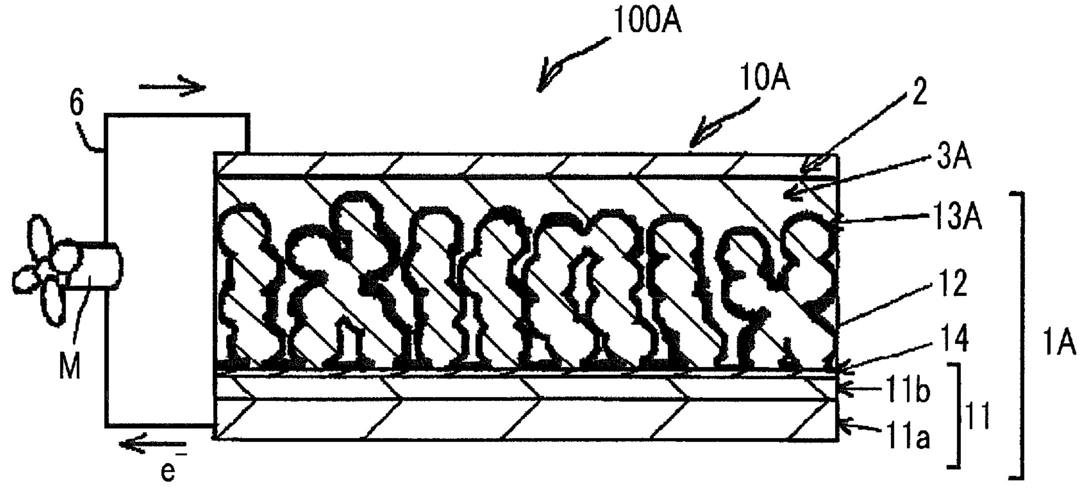
100A
10A
2
3A
13A
12
14
1A
11b
11a
11
6
M
e⁻

FIG. 2

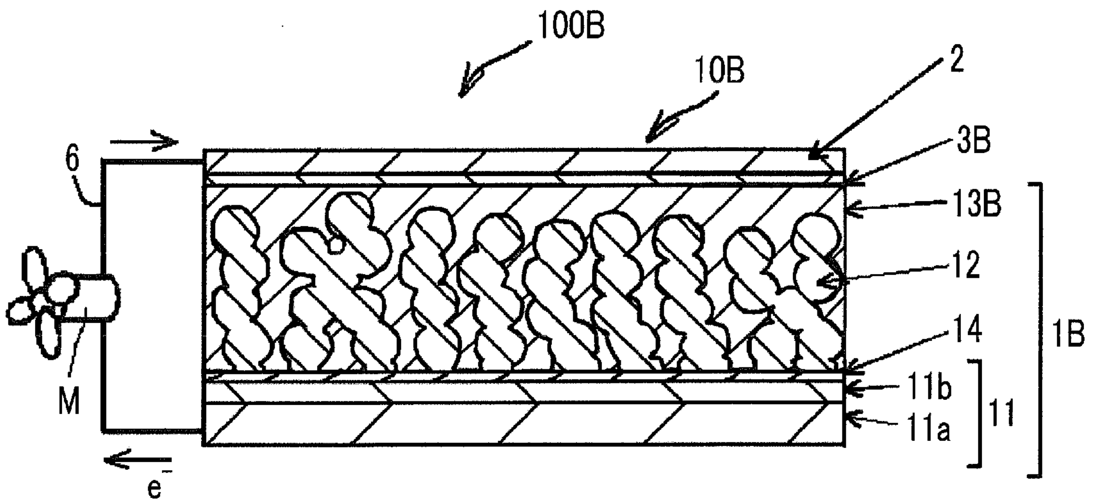
100B
10B
2
3B
13B
12
14
1B
11b
11a
11
6
M
e⁻

FIG. 3

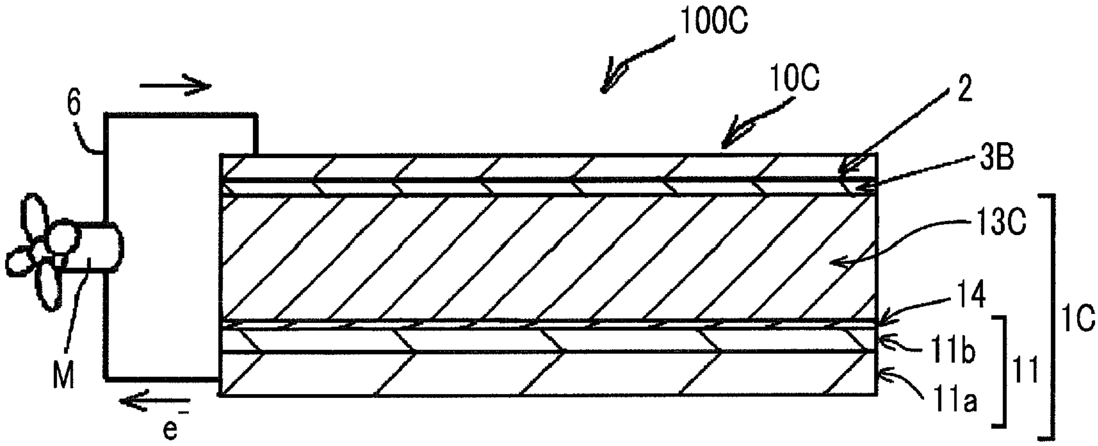

**INTERNATIONAL SEARCH REPORT**

International application No. PCT/JP2015/082559

A. CLASSIFICATION OF SUBJECT MATTER
*H01L51/46*(2006.01)i, *H01L51/44*(2006.01)i

According to International Patent Classification (IPC) or to both national classification and IPC

B. FIELDS SEARCHED

Minimum documentation searched (classification system followed by classification symbols)
H01L31/02-31/078, 31/18-31/20, 51/42-51/48, H02S10/00-10/40, 30/00-50/15, 99/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
Science Direct, IEEE Xplore, CiNii

C. DOCUMENTS CONSIDERED TO BE RELEVANT

| Category* | Citation of document, with indication, where appropriate, of the relevant passages | Relevant to claim No. |
|---|---|---|
| X<br>A | EP 2747101 A1 (SWANSEA UNIVERSITY), 25 June 2014 (25.06.2014), paragraphs [0014] to [0016], [0024] to [0030], [0055], [0063] to [0069]; fig. 1<br>& US 2015/0325719 A1 & WO 2014/095060 A1 | 9<br>1-8 |
| Y<br>A | WO 2014/084133 A1 (Sekisui Chemical Co., Ltd.), 05 June 2014 (05.06.2014), paragraphs [0046] to [0052], [0057] to [0060]; table 1<br>& JP 2015-15474 A & JP 5617051 B<br>& CN 104813497 A & EP 2927980 A1<br>paragraphs [0066] to [0073], [0078] to [0084]; table 1<br>& KR 10-2015-0090022 A & TW 201428991 A | 9<br>1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 January 2016 (18.01.16) | 26 January 2016 (26.01.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2015/082559

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2007-115665 A (Samsung Electronics Co., Ltd.), 10 May 2007 (10.05.2007), paragraph [0071] & US 2007/0085051 A1 paragraph [0061] & EP 1777227 A1 & KR 10-2007-0042274 A | 9 |
| Y | JP 2007-13115 A (Ricoh Co., Ltd.), 18 January 2007 (18.01.2007), paragraphs [0133], [0149], [0190] (Family: none) | 9 |
| P,X | JP 2015-138822 A (Kyoto University), 30 July 2015 (30.07.2015), paragraphs [0069] to [0074], [0111] to [0122], [0125] to [0134] (Family: none) | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2014045021 A
- JP 2001291534 A
- US 4927721 A
- US 4684537 A
- US 5084365 A
- US 5350644 A
- US 5463057 A
- US 5525440 A
- JP 7249790 A
- JP H7249790 A
- JP 2004220974 A
- JP 2008135197 A
- JP 2005135902 A
- JP 2001160425 A
- JP 2003123859 A
- JP 2002260746 A
- JP 2014236632 A


### Non-patent literature cited in the description


- *Journal of the American Chemical Society,* 2014, vol. 136, 7, , 837-7, 840
- **DAVID R. LIDE.** CRC HANDBOOK OF CHEMISTRY and PHYSICS. CRC PRESS, 2007
- **AKIHIRO KOJIMA ; KENJIRO TESHIMA ; YASUO SHIRAI ; TSUTOMU MIYASAKA.** Organometal Halide Perovskites as Visible-Light Sensitizers for Photovoltaic Cells. *J. Am. Chem. Soc.,* 2009, vol. 131 (17), 6, , 050-6, 051
- *Journal of the American Chemical Society,* 2014, vol. 136, 7, , 837-7, 840
- *Chemical Review,* 2010, vol. 110, 6595